# EUROPEAN PATENT SPECIFICATION

(11) **EP 3 029 740 B1**
(45) Date of publication and mention of the grant of the patent: **17.07.2019**
(21) Application number: 15197334.4
(22) Date of filing: 01.12.2015
(51) Int. Cl.: H01L 31/0224, H01L 31/0236, H01L 31/0376, H01L 31/0747, H01L 31/20

(54) **PHOTOVOLTAIC DEVICE**
PV-ELEMENT
DISPOSITIF PHOTOVOLTAÏQUE

(30) Priority: 03.12.2014 JP 2014245262
(43) Date of publication of application: 08.06.2016
(73) Proprietor: Sharp Kabushiki Kaisha, Osaka-shi, Osaka 545-8522 (JP)
(72) Inventor: HARADA, Masatomi, Osaka, 545-8522 (JP); KAMIKAWA, Takeshi, Osaka, 545-8522 (JP); SAKAI, Toshihiko, Osaka, 545-8522 (JP); KUNIYOSHI, Tokuaki, Osaka, 545-8522 (JP); ZOU, Liumin, Osaka, 545-8522 (JP)
(74) Representative: Müller Hoffmann & Partner

(56) References cited:
- WO-A1-03/083955
- WO-A1-2011/149021
- CN-A- 103 346 211
- US-A1- 2010 032 014

## Description

### BACKGROUND

### Technical Field

The present invention relates to a photovoltaic device.

### Description of the Background Art

JP 2011-155229 A discloses a backside-electrode-based solar cell including an n-type single-crystal silicon substrate having a backside on which a plurality of n-type semiconductor strips and a plurality of p-type semiconductor strips provided in an alternate manner and electrodes are provided on top of them. The backside-electrode-based solar cell of JP 2011-155229 A has a hetero-junction construction in which an amorphous silicon layer is stacked upon the n-type single-crystal silicon substrate.

Since an amorphous silicon layer has a low conductivity, when a horizontal gap is present between the amorphous silicon layer and the electrodes provided on top of it, carriers cannot move in the amorphous silicon layer such that the carrier cannot be collected efficiently. Further, providing an amorphous silicon layer on a single-crystal silicon substrate results in higher contact resistance between the single-crystal silicon substrate and amorphous silicon layer. To solve these problems, the distance between the electrodes may be reduced to reduce the horizontal gap area and increase the area where the amorphous silicon layer and electrodes are joined.

However, when electrodes are formed using a shadow mask, the smaller the distance between the electrodes, the smaller the distance between the openings in the shadow mask such that the shadow mask can easily bend. As such, part of an electrode on a p-type semiconductor strip may be on an n-type semiconductor region or part of an electrode on an n-type semiconductor strip may be on a p-type semiconductor region, causing a short circuit in the p-n junction. WO 2011/149021 A1 discloses a method for manufacturing a photovoltaic element and a photovoltaic element. Intrinsic amorphous semiconductor films are formed on one surface of an n-type single crystal silicon substrate, an n-type conductive section (n-type amorphous semiconductor film) is formed on the surface of the intrinsic amorphous semiconductor film using a first mask, a p-type conductive section (p-type amorphous semiconductor film) is formed on the surface of the intrinsic amorphous semiconductor film using a second mask, an insulating film is formed such that at least the n-type single crystal silicon substrate surface is covered, said surface having the amorphous semiconductor films formed thereon, a plurality of conductive holes communicating with the amorphous semiconductor films are formed in the insulating film, and electrodes are formed in a region on the insulating film that includes the conductive holes, thereby obtaining the photovoltaic element.
US 2010/032014 A1 discloses a photovoltaic device which includes: a substrate based on a crystalline semi-conductor material; a first electrode which includes at least one heterojunction made on one face, referred to as the rear face, of the substrate, where this heterojunction includes a layer based on a doped amorphous semi-conductor material; and a second electrode. The first and second electrodes are arranged on the rear face of the substrate according to an interdigitated combs design, and where the layer includes multiple portions of the doped amorphous semi-conductor material which are unconnected and spaced apart from each other.
WO 03/083955 A1 discloses a rear-junction type photovoltaic element, in which a p-n junction and electrodes are formed on a rear surface opposite to a light incident surface of a (semiconductor) silicon substrate. The photovoltaic element has an intrinsic semiconductor film having a thickness ranging from 0.1 nm to 50 nm. The intrinsic semiconductor film is disposed on the rear surface of the semiconductor substrate. P-type conductive semiconductor portions and n-type conductive semiconductor portions are disposed on the intrinsic semiconductor film, respectively. A first electrode and a second electrode are connected to the p-type conductive semiconductor portions and the n-type conductive semiconductor portions, respectively.
CN 103 346 211 A discloses a back contact solar battery and a preparing method of the back contact solar battery. The preparing method of the back contact solar battery includes the steps of providing a first mould slide boat and a second mould slide boat, wherein the first mould slide boat comprises first film growing areas and first shielding areas which are distributed alternatively, and the second mould slide boat comprises second film growing areas and second shielding areas which are distributed alternatively, the first film growing areas correspond to the second shielding areas, and the second film growing areas correspond to the first shielding areas. First doped amorphous silicon indication areas and second doped amorphous silicon indication areas are formed on the surfaces, with passivated layers, of monocrystalline silicon substrates through the mould slide boats, wherein the first doped amorphous silicon indication areas and the second doped amorphous silicon indication areas are opposite in doping type and crossed in distribution. By means of the preparing method, a fork structure of a back field of the back contact solar battery is achieved.

An object of the present invention is to provide a photovoltaic device that prevents a short circuit in an p-n junction even if the distance between the electrodes on the n-type semiconductor strips and the electrodes on the p-type semiconductor strips is reduced.

### SUMMARY

This object is solved by the subject-matter of claim 1.

A photovoltaic device according to the present invention includes: a semiconductor substrate; a first amorphous semiconductor strip of a first conductivity type provided on one face of the semiconductor substrate; a second amorphous semiconductor strip of a second conductivity type, the second conductivity type being opposite to the first conductivity type, the second amorphous semiconductor strip being provided on the one face of the semiconductor substrate and located adjacent to the first amorphous semiconductor strip in an in-plane direction of the semiconductor substrate; a plurality of electrodes spaced apart from each other and provided on at least one of the first and second amorphous semiconductor strips; and a conductive part provided on the plurality of electrodes for electrically connecting the plurality of electrodes.

The present invention prevents a short circuit in a p-n junction even if the distance between the electrodes on the n-type semiconductor strips and the electrodes on the p-type semiconductor strips is reduced.

### BRIEF DESCRIPTION OF THE DRAWINGS

FIG. 1 is a schematic plan view of a photovoltaic device in a first embodiment.
FIG. 2A is a schematic cross-sectional view of the photovoltaic device of FIG. 1 taken along line A-A.
FIG. 2B is a schematic cross-sectional view of the photovoltaic device of FIG. 1 taken along line B-B.
FIG. 3 is a schematic plan view of a wiring sheet in the first embodiment.
FIG. 4A is a schematic cross-sectional view of a photovoltaic device having the photovoltaic device of FIG. 1 joined to the wiring sheet of FIG. 3.
FIG. 4B is a schematic cross-sectional view of a photovoltaic device having the photovoltaic device of FIG. 1 joined to the wiring sheet of FIG. 3.
FIG. 5A illustrates a step for fabricating the photovoltaic device of FIG. 1 and is a cross-sectional view of a silicon substrate on which a texture has been formed.
FIG. 5B is a cross-sectional view of the silicon substrate of FIG. 5A where an antireflective film has been formed on its light-receiving face.
FIG. 5C is a cross-sectional view of the silicon substrate of FIG. 5B where an i-type amorphous semiconductor layer and p-type amorphous semiconductor strips have been formed on its back face.
FIG. 5D is a cross-sectional view of the silicon substrate of FIG. 5C where n-type amorphous semiconductor strips have been formed on its back face.
FIG. 5E is a cross-sectional view of the substrate where electrodes have been formed on the p-type amorphous semiconductor strips and n-type amorphous semiconductor strips of FIG. 5D.
FIG. 6A schematically shows p-type amorphous semiconductor strips formed using a shadow mask.
FIG. 6B schematically shows n-type amorphous semiconductor strips formed using a shadow mask.
FIG. 6C schematically shows electrodes formed using a shadow mask.
FIG. 6D illustrates the relationship between the dimension of the gaps between the electrodes and yield in the first embodiment and comparative examples.
FIG. 6E is a schematic view of a shadow mask used to form the electrodes in the comparative examples of FIG. 6D.
FIG. 7A shows an example schematic cross-section of a p-type amorphous semiconductor strip.
FIG. 7B shows another example schematic cross-section of a p-type amorphous semiconductor strip.
FIG. 7C shows a yet another example schematic cross-section of a p-type amorphous semiconductor strip.
FIG. 7D(a) schematically illustrates measurements of the film thickness, i.e. the distance between the interface between the i-type amorphous semiconductor layer and the surface of the silicon substrate to the surface of an amorphous semiconductor layer; FIG. 7D(b) schematically illustrates the thicknesses shown in FIG. 7D(a) as plotted.
FIG. 8A illustrates a step for fabricating the wiring sheet of FIG. 3 and is a cross-sectional view of an insulating substrate on which a conductive layer has been formed.
FIG. 8B is a cross-sectional view of the substrate where a resist pattern has been formed on the conductive layer of FIG. 8A.
FIG. 8C is a cross-sectional view of the substrate where the conductive layer of FIG. 8B has been patterned.
FIG. 8D is a cross-sectional view of the substrate where the resist pattern of FIG. 8C has been removed.
FIG. 9A is a schematic cross-sectional view of the wiring sheet of FIG. 3 and the photovoltaic device of FIG. 1 to be joined together.
FIG. 9B is a cross-sectional view of the wiring sheet of FIG. 9A and the photovoltaic device joined together.
FIG. 10A illustrates a step for joining the wiring sheet of FIG. 3 to the photovoltaic device of FIG. 1 and is a cross-sectional view of the photovoltaic device where solder resin pieces have been formed on the electrodes of the photovoltaic device.
FIG. 10B is a cross-sectional view illustrating the step of aligning the photovoltaic device of FIG. 10A with the wiring sheet of FIG. 3.
FIG. 10C is a cross-sectional view of the photovoltaic device and wiring sheet of FIG. 10B attached to each other.
FIG. 10D is a cross-sectional view of the device of FIG. 10B after the solder resin has been cured.
FIG. 11A is a schematic plan view of a photovoltaic device in a second embodiment.
FIG. 11B is a schematic view of a shadow mask used to form the p-type amorphous semiconductor strip of FIG. 11A.
FIG. 11C is a schematic view of a shadow mask used to form the n-type amorphous semiconductor strip of FIG. 11A.
FIG. 11D is a schematic view of a shadow mask used to form the electrodes of FIG. 11A.
FIG. 12A is a schematic plan view of a photovoltaic device in a third embodiment.
FIG. 12B is a schematic view of a shadow mask used to form the electrodes of FIG. 12A.
FIG. 13A is a schematic plan view of a photovoltaic device in a fourth embodiment.
FIG. 13B is an enlarged schematic view of a portion of the photovoltaic device of FIG. 13A.
FIG. 13C is a schematic cross-sectional view of the photovoltaic device of FIG. 13B taken along line I-I.
FIG. 14A is a schematic plan view of a photovoltaic device in a fifth embodiment.
FIG. 14B is an enlarged schematic view of a portion of the photovoltaic device of FIG. 14A.
FIG. 14C is a schematic cross-sectional view of the photovoltaic device of FIG. 14B taken along line II-II.
FIG. 15 is a schematic cross-sectional view of a photovoltaic device in a sixth embodiment.
FIG. 16 is a schematic diagram of a photovoltaic module in a seventh embodiment.
FIG. 17A is a schematic diagram of a solar power generation system including the photovoltaic device in the seventh embodiment.
FIG. 17B is a schematic diagram of another configuration of the solar power generation system of FIG. 17A.
FIG. 18 is a schematic diagram of the photovoltaic module array of FIG. 17A.
FIG. 19A is a schematic diagram of a solar power generation system including photovoltaic devices in the eighth embodiment.
FIG. 19B is a schematic diagram of another configuration of the solar power generation system of FIG. 19A.

### DESCRIPTION OF THE EMBODIMENTS

A photovoltaic device in an embodiment of the present invention includes: a semiconductor substrate; a first amorphous semiconductor strip of a first conductivity type provided on one face of the semiconductor substrate; a second amorphous semiconductor strip of a second conductivity type, the second conductivity type being opposite to the first conductivity type, the second amorphous semiconductor strip being provided on the one face of the semiconductor substrate and located adjacent to the first amorphous semiconductor strip in an in-plane direction of the semiconductor substrate; a plurality of electrodes spaced apart from each other and provided on at least one of the first and second amorphous semiconductor strips; and a conductive part provided on the plurality of electrodes for electrically connecting the plurality of electrodes (first arrangement).

In the first arrangement, the photovoltaic device includes a plurality of electrodes provided on at least one of a first amorphous semiconductor strip of a first conductivity type and a second amorphous semiconductor strip of a second conductivity type provided on a semiconductor substrate, the plurality of electrodes being spaced apart from each other. The electrodes are electrically connected via a conductive part provided on the electrodes. If the electrodes are formed using a shadow mask, the area between the openings in the shadow mask is larger if a plurality of electrodes spaced apart from each other are provided than if one continuous electrode is provided on each of the semiconductor strips, and thus the shadow mask is less likely to bend. Thus, even if the gap between the electrodes on the first and second amorphous semiconductor strips is reduced, desired electrodes are formed on the first and second amorphous semiconductor strips such that a short circuit in a p-n junction is less likely to occur. Further, the electrodes spaced apart from each other are electrically connected via the conductive part, allowing a current produced by the photovoltaic device to be taken out via the conductive part.

A photovoltaic device in an embodiment of the present invention includes: a semiconductor substrate; a first amorphous semiconductor strip of a first conductivity type provided on one face of the semiconductor substrate, the first amorphous semiconductor strip being comb-shaped; a second amorphous semiconductor strip of a second conductivity type, the second amorphous semiconductor strip being provided on the one face of the semiconductor substrate and comb-shaped and located adjacent to the first amorphous semiconductor strip in an in-plane direction of the semiconductor substrate, the second conductivity type being opposite to the first conductivity type; a plurality of comb-shaped electrodes provided on at least one of the first and second amorphous semiconductor strips; and a conductive part provided on the plurality of electrodes for electrically connecting the plurality of electrodes, wherein each of the electrodes includes a first electrode portion extending generally in a first direction on the semiconductor substrate and a plurality of second electrode portions extending generally in a second direction and being in contact with one side of the first electrode portion, the second direction being perpendicular to the first direction, and the plurality of electrodes are disposed such that the first electrode portions are spaced apart from each other in the first direction (second arrangement).

In the second arrangement, the photovoltaic device includes a first amorphous semiconductor strip of a first conductivity type and a second amorphous semiconductor strip of a second conductivity type, the strips being provided on a semiconductor substrate and being comb-shaped. The photovoltaic device further includes a plurality of comb-shaped electrodes provided on at least one of the first and second amorphous semiconductor strips. Each electrode includes a first electrode portion and a plurality of second electrode portions extending generally perpendicular to the first electrode portion, and the second electrode portions are in contact with one side of the first electrode portion. The electrodes are disposed such that the first electrode portions are spaced apart from each other, and are electrically connected via a conductive part located on the electrodes. If the electrodes are formed using a shadow mask, the area between the openings in the shadow mask is larger if a plurality of electrodes spaced apart from each other are provided than if one continuous electrode is provided on each of the semiconductor strips, and thus the shadow mask is less likely to bend. Thus, even if the gap between the electrodes on the first and second amorphous semiconductor strips is reduced, desired electrodes are formed on the first and second amorphous semiconductor strips such that a short circuit in a p-n junction is less likely to occur. Further, the electrodes spaced apart from each other are electrically connected via the conductive part, allowing a current produced by the photovoltaic device to be taken out via the conductive part.

In a photovoltaic device with a third arrangement, starting from the first arrangement, some of the plurality of electrodes provided on the first and second amorphous semiconductor strips may be located at positions that correspond to positions between the electrodes on the adjacent semiconductor strips.

If electrodes are formed using a shadow mask such that the positions of the electrodes on adjacent semiconductor strips are aligned, the positions of the openings in the shadow mask for forming the electrodes on the adjacent semiconductor strips are aligned, and thus the smaller the distance between the openings, the more likely the shadow mask is to bend. In the third arrangement, the positions of the electrodes on adjacent semiconductor strips are not aligned, and thus the shadow mask is less likely to bend while the electrodes are being formed using the shadow mask, enabling fabricating desired electrodes on the semiconductor strips and preventing a short circuit in a p-n junction.

In a photovoltaic device with a fourth arrangement, starting from one of the first to third arrangements, the conductive part may include a conductive layer made of a metal paste.

In the fourth arrangement, a current produced by the photovoltaic device can be taken out via the conductive layer.

In a photovoltaic device with a fifth arrangement, starting from the fourth arrangement, the conductive layer may be located on the plurality of electrodes and between adjacent ones of the electrodes.

In the fifth arrangement, a current produced by the photovoltaic device can be taken out not only via the electrodes spaced apart from each other but also via the conductive layer provided between the electrodes, thereby improving the fill factor of the photovoltaic device.

In a photovoltaic device with a sixth arrangement, starting from the fourth arrangement, the conductive layer may be provided on the plurality of electrodes and provided so as to bridge adjacent ones of the electrodes.

In the sixth arrangement, a current produced by the photovoltaic device can be taken out not only via the electrodes spaced apart from each other but also via the conductive layer straddling the spaces between the electrodes. Further, the area where the conductive layer is present is larger than in the fifth arrangement, which increases the area where it contacts the wiring connected with the photovoltaic device, thereby providing wiring connection with a lower resistance than in the fifth arrangement.

In a photovoltaic device with a seventh arrangement, starting from one of the first to sixth arrangements, at least one face of the semiconductor substrate may have a texture.

The seventh arrangement reduces the reflectance of at least one face of the semiconductor substrate, thereby increasing short-circuit currents.

In a photovoltaic device with an eighth arrangement, starting from one of the first to seventh arrangements, an insulating layer may be provided in a region that is other than a region in which the conductive part is in contact with the plurality of electrodes.

The eighth arrangement electrically connects the electrodes in the photovoltaic device in a more stable manner.

Embodiments of the photovoltaic device of the present invention will be described in more detail with reference to the drawings. As used herein, photovoltaic device means a photovoltaic element, a photovoltaic module using photovoltaic elements, and a solar cell power generation system including photovoltaic modules. The same or corresponding components in the drawings are labeled with the same characters and their description will not be repeated. For ease of explanation, the drawings to which reference will be made hereinafter show the configurations in a simplified or schematic manner, or do not show some components. The size ratios of the components shown in the drawings do not necessarily indicate the actual size ratios.

### <First Embodiment>

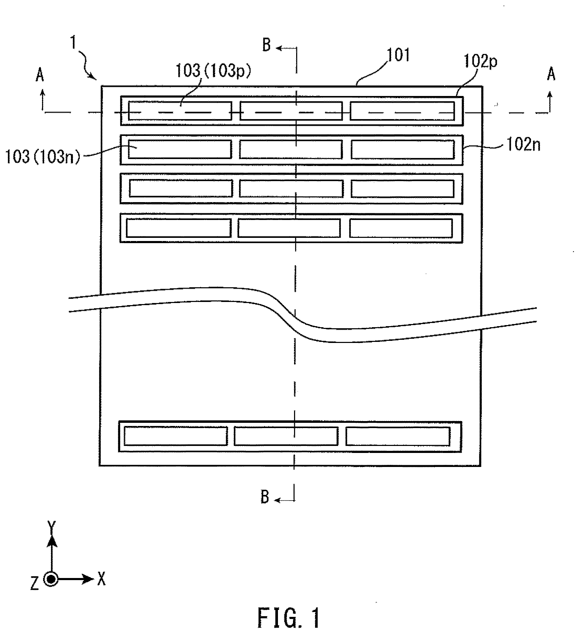

FIG. 1 is a schematic plan view of a photovoltaic device in a first embodiment of the present invention. The photovoltaic device 1 includes a silicon substrate 101, n-type amorphous semiconductor strips 102n, p-type amorphous semiconductor strips 102p and electrodes 103.

The silicon substrate 101 may be, for example, an n-type single-crystal silicon substrate. The silicon substrate 101 may have a thickness of 100 to 150 µm, for example.

The p-type amorphous semiconductor strips 102p and n-type amorphous semiconductor strips 102n are generally rectangular in shape. The p-type amorphous semiconductor strips 102p and n-type amorphous semiconductor strips 102n are provided on the silicon substrate 101 and located adjacent to each other to cover substantially the entire surface of the silicon substrate 101.

A plurality of generally rectangular electrodes 103 are provided on each of the p-type and n-type amorphous semiconductor strips 102p and 102n and extend in the longitudinal direction of the p-type and n-type amorphous semiconductor strips 102p and 102n. The electrodes 103 on the p-type and n-type amorphous semiconductor strips 102p and 102n are disposed such that separate electrodes are provided on each of the semiconductor strips.

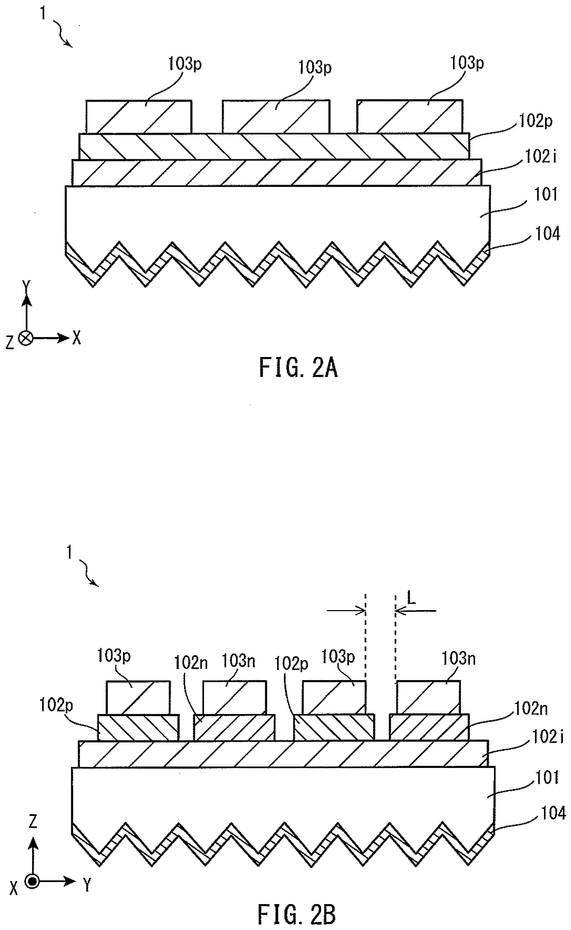

FIG. 2A is a schematic cross-sectional view of the photovoltaic device 1 of FIG. 1 taken along line A-A. FIG. 2B is a schematic cross-sectional view of the photovoltaic device 1 of FIG. 1 taken along line B-B.

As shown in FIGS. 2A and 2B, a texture is provided on one face of the silicon substrate 101 (negative along the Z-axis). The texture reduces the surface reflectance of the silicon substrate 101 and increases short-circuit currents. In the following description, the face with a texture will be referred to as light-receiving face of the silicon substrate 101, and the other face (positive along the Z-axis) will be referred to as back face.

An antireflective film 104 is provided to cover the surface of the silicon substrate 101. The antireflective film 104 may include, for example, a silicon oxide film with a thickness of about 20 nm and a silicon nitride film with a thickness of about 60 nm, deposited in this order. The antireflective film 104 reduces the surface reflectance of the silicon substrate 101 and increases short-circuit currents.

An i-type amorphous semiconductor layer 102i is provided on the back face of the silicon substrate 101. The i-type amorphous semiconductor layer 102i is a film of a substantially intrinsic amorphous semiconductor containing hydrogen. The i-type amorphous semiconductor film 102i may be made of, for example, i-type amorphous silicon, i-type amorphous silicon-germanium, i-type amorphous germanium, i-type amorphous silicon carbide, i-type amorphous silicon nitride, i-type amorphous silicon oxide, i-type amorphous silicon-carbon oxide. The i-type amorphous semiconductor layer 102i may have a thickness of several A to 25 nm, for example.

The p-type amorphous semiconductor strips 102p and n-type amorphous semiconductor strips 102n are provided on the i-type amorphous semiconductor layer 102i.

The n-type amorphous semiconductor strips 102n are constituted by an n-type amorphous semiconductor layer containing hydrogen. The n-type amorphous semiconductor strips 102n may be made of, for example, n-type amorphous silicon, n-type amorphous silicon-germanium, n-type amorphous germanium, n-type amorphous silicon carbide, n-type amorphous silicon nitride, n-type amorphous silicon oxide, n-type amorphous silicon oxynitride, n-type amorphous silicon-carbon oxide containing phosphorous (P) as an impurity, for example. The n-type amorphous semiconductor strips 102n may have a thickness of 3 to 50 nm, for example.

The p-type amorphous semiconductor strips 102p are constituted by a p-type amorphous semiconductor layer containing hydrogen. The p-type amorphous semiconductor strips 102p may be made of, for example, p-type amorphous silicon, p-type amorphous silicon-germanium, p-type amorphous germanium, p-type amorphous silicon carbide, p-type amorphous silicon nitride, p-type amorphous silicon oxide, p-type amorphous silicon oxynitride, p-type amorphous silicon-carbon oxide containing boron (B) as an impurity, for example. The p-type amorphous semiconductor strips 102p may have a thickness of 5 to 50 nm, for example.

As used herein, amorphous semiconductor also means one containing a microcrystalline phase. The microcrystalline phase contains crystals with a mean particle size of 1 to 50 nm.

On each of the p-type and n-type amorphous semiconductor strips 102p and 102n are provided a plurality of electrodes 103 that are in contact with the associated p-type or n-type semiconductor strip 102p or 102n. An electrode 103 in contact with a p-type amorphous semiconductor strip 102p will be hereinafter referred to as p-type electrode 103p, and an electrode 103 in contact with an n-type amorphous semiconductor strip 102n will be referred to as n-type electrode 103n.

As shown in FIG. 2B, an n-type electrode 103n and a p-type electrode 103p are spaced apart from each other by a distance L. The n-type and p-type electrodes 103n and 103p may be made of, for example, a metal such as silver (Ag), nickel (Ni), aluminum (Al), copper (Cu), tin (Sn), platinum (Pt), gold (Au) and titanium (Ti), an oxide conductive film such as ITO, or an alloy of some of these metals or a laminate of some of these metals. The n-type and p-type electrodes 103n and 103p are preferably made of a metal with high conductivity. The n-type and p-type electrodes 103n and 103p may have a thickness of about 50 nm to 1 µm, for example.

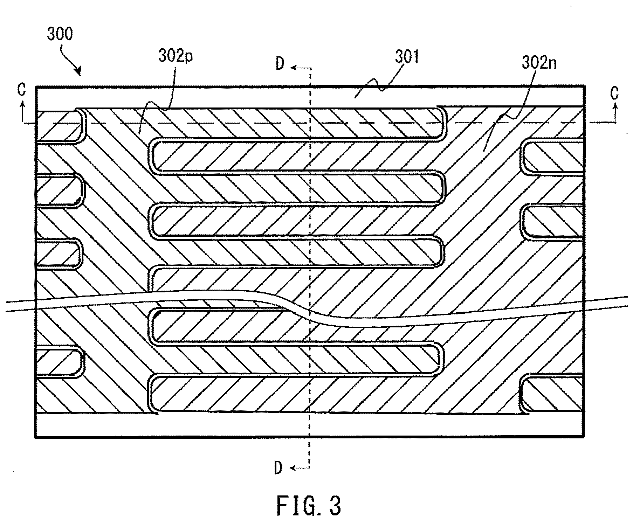

When photovoltaic devices 1 are combined into a module, each photovoltaic device 1 is electrically connected with an external wiring circuit (hereinafter referred to as wiring sheet). FIG. 3 is an enlarged schematic view of a portion of a wiring sheet in the present embodiment.

The wiring sheet 300 includes an insulating substrate 301, on which an n-type wiring member 302n and a p-type wiring member 302p are provided.

The insulating substrate 301 may be made of any insulating material, such as polyethylene terephthalate (PET), polyethylene naphthalate (PEN), polyphenyline sulfide (PPS), polyvinyl fluoride (PVF), or polyimide. The thickness of the insulating substrate 301 is not limited to any particular value, and is preferably not smaller than about 25 µm and smaller than about 150 µm. The insulating substrate 301 may have a single-layer structure or a multi-layer structure with two or more layers.

The n-type wiring member 302n and p-type wiring member 302p are comb-shaped and have teeth disposed alternately and spaced apart by a predetermined distance. The n-type and p-type electrodes 103n and 103p provided on the back face of the photovoltaic device 1 are joined to the n-type and p-type wiring members 302n and 302p, respectively. Connection wiring (not shown) is provided on the surface of the insulating substrate 301, where the n-type and p-type wiring members 302n and 302p are electrically connected via the connection wiring and adjacent photovoltaic devices 1 on the wiring sheet 300 are also electrically connected via the connection wiring.

The n-type and p-type wiring members 302n and 302p are made of any conductive material, and may be made of one of Cu, Al, Ag and other metals or an alloy mainly composed of one of these metals. The thickness of the n-type and p-type wiring members 302n and 302p is not limited to any particular value and is preferably not smaller than 10 µm and not larger than 100 µm, for example. If the thickness of the n-type and p-type wiring member 302n and 302p is not larger than 10 µm, the wiring resistance may be too high. If the thickness is not smaller than 100 µm, heat must be applied when the n-type and p-type wiring members 302n and 302p are to be attached to the photovoltaic device 1. As such, for a thickness of 100 µm or larger, differences between the thermal expansion coefficients of the n-type and p-type wiring members 302n and 302p and that of the silicon substrate 101 of the photovoltaic device 1 cause the wiring sheet 300 to warp significantly. In view of this, the thickness of the n-type and p-type wiring members 302n and 302p is more preferably not larger than 100 µm. Further, a conductive material such as nickel, gold, platinum, palladium, silver, tin, indium or ITO may be provided on portions of the surfaces of the n-type and p-type wiring members 302n and 302p. This construction provides good electrical connection between the n-type and p-type wiring members 302n and 302p and the n-type and p-type electrodes 103n and 103p of the photovoltaic device 1, thereby improving the weather resistance of the n-type and p-type wiring members 302n and 302p. The n-type and p-type wiring members 302n and 302p may have a single-layer structure or a multi-layer structure with two or more layers.

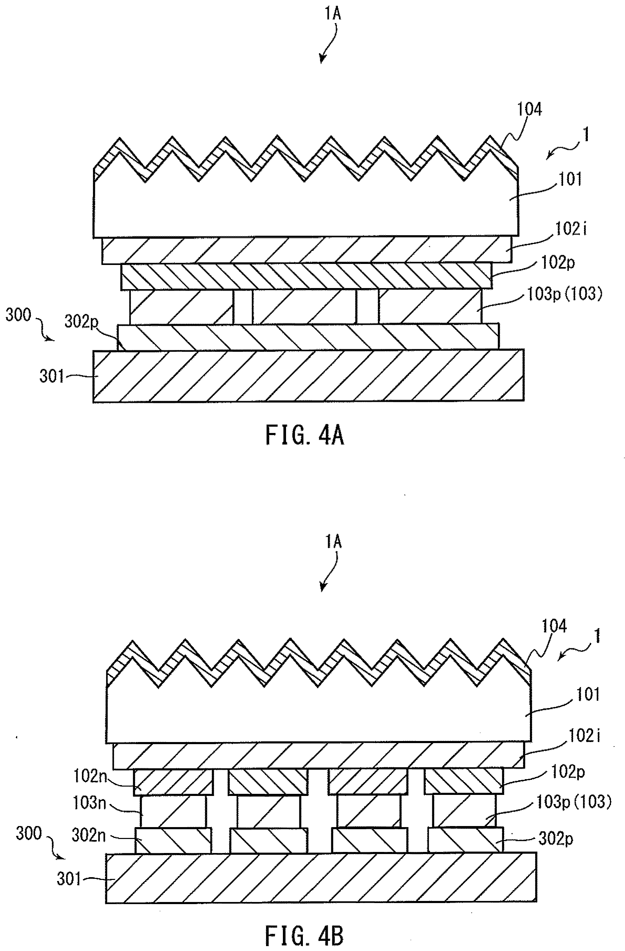

FIGS. 4A and 4B show schematic cross-sectional views of a photovoltaic device 1A having the wiring sheet 300 joined to the photovoltaic device 1. FIG. 4A shows a cross-section of the photovoltaic device 1 of FIG. 1 taken along line A-A and a cross-section of the wiring sheet 300 of FIG. 3 taken along line C-C. FIG. 4B shows a cross-section of the photovoltaic device 1 of FIG. 1 taken along line B-B and a cross-section of the wiring sheet 300 of FIG. 3 taken along line D-D.

As shown in FIGS. 4A and 4B, a plurality of p-type electrodes 103p spaced apart from each other are provided on each p-type amorphous semiconductor strip 102p to extend in the longitudinal direction thereof. The p-type electrodes 103p are electrically connected with each other via the p-type wiring member 302p on the wiring sheet 300. Although not shown, a plurality of n-type electrodes 103n spaced apart from each other are provided on each n-type amorphous semiconductor strip 102n to extend in the longitudinal direction thereof, where the n-type electrodes 103n are electrically connected with each other via the n-type wiring member 302n on the wiring sheet 300. Thus, a current produced as light enters the light-receiving face of the photovoltaic device 1 can be taken out toward the outside via the p-type and n-type wiring members 302p and 302n.

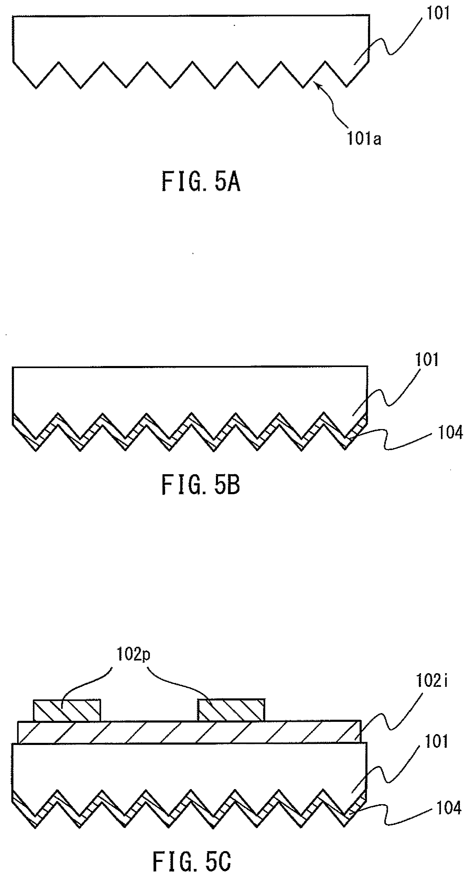

An example method of manufacturing the photovoltaic device 1A will now be described with reference to FIGS. 5A to 5E.

First, a bulk of silicon is provided and a wafer with a thickness of 100 to 300 µm is cut out therefrom, and the wafer is etched to remove the damaged layer on the surface of the wafer and is etched to adjust its thickness. A protective film is formed on one side of the etched wafer. The protective film may be, for example, silicon oxide or silicon nitride. The wafer with the protective film is wet-etched using an alkaline solution such as NaOH or KOH (for example, an aqueous solution having KOH in 1 to 5 wt% and isopropyl alcohol in 1 to 10 wt%). At this time, a texture is formed due to anisotropic etching on the surface 101a that has no protective film. Removing the protective film after the etching leaves the silicon substrate 101 shown in FIG. 5A.

Next, as shown in FIG. 5B, an antireflective film 104 is provided on the light-receiving face 101a of the silicon substrate 101. An antireflective film 104 with a laminate structure with a silicon oxide film and a silicon nitride film stacked on top of each other will be described below.

In this implementation, first, the surface of the silicon substrate 101 is subjected to thermal oxidation to form an oxide film on the light-receiving face 101a. Thereafter, a silicon nitride film is formed on the oxide film of the light-receiving face 101a to form an antireflective film 104. The silicon substrate 101 may be oxidized by either wet treatment or thermal oxidation. If wet treatment is used, for example, the silicon substrate 101 is immersed in hydrogen peroxide, nitric acid or ozonated water, and then is heated in a dry atmosphere to a temperature ranging from 800 to 1000 °C. If thermal oxidation is used, for example, the silicon substrate 101 is heated in an oxygen or water vapor atmosphere to a temperature ranging from 900 to 1000 °C. The silicon nitride film may be formed by sputtering, electron beam (EB) evaporation, or tetraethoxysilane (TEOS) method.

An i-type amorphous semiconductor layer and n-type amorphous semiconductor strips may be successively formed between the silicon substrate 101 and the silicon nitride film.

The i-type amorphous semiconductor layer, n-type amorphous semiconductor strips and silicon nitride film may be formed by, for example, plasma chemical vapor deposition (CVD). For the i-type amorphous semiconductor layer, the reactant gas to be introduced into the reaction chamber of the plasma CVD equipment includes silane gas and hydrogen gas. In this case, for example, the temperature of the silicon substrate 101 may be in the range of 130 to 210 °C, the hydrogen gas flow rate may be in the range of 0 to 100 sccm, the silane gas (SiH₄) flow rate may be about 40 sccm, the pressure in the reaction chamber may be in the range of 40 to 120 Pa, and the high frequency (13.56 MHz) power density may be in the range of 5 to 15 mW/cm².

For the n-type amorphous semiconductor strips, the reactant gas to be introduced into the reaction chamber of the plasma CVD equipment includes silane gas, hydrogen gas, and phophine gas (PH₃) diluted with hydrogen (with a phosphine concentration of 1 %, for example). In this case, the hydrogen gas flow rate may be in the range of 0 to 100 sccm, the silane gas flow rate may be 40 sccm, the phosphine gas flow rate may be 40 sccm, the temperature of the silicon substrate 101 may be in the range of 130 to 180 °C, for example, the pressure in the reaction chamber may be about 40 Pa, and the high frequency power density may be 8.33 mW/cm². Thus, n-type amorphous semiconductor strips 102n doped with phosphorus are formed.

Next, on the back face of the silicon substrate 101, i.e. the face opposite the light-receiving face 101a are successively formed an i-type amorphous semiconductor layer 102i and p-type amorphous semiconductor strips 102p.

More specifically, first, on the back face of the silicon substrate 101 is formed an i-type amorphous semiconductor layer 102i by plasma CVD. At this time, the i-type amorphous semiconductor layer 102i is formed over the entire back face of the silicon substrate 101. When the i-type amorphous semiconductor layer 102i is to be formed, the reactant gas to be introduced into the reaction chamber of the plasma CVD equipment includes silane gas and hydrogen gas. In this case, for example, the temperature of the silicon substrate 101 may be in the range of 130 to 210 °C, the hydrogen gas flow rate may be in the range of 0 to 100 sccm, the silane gas (SiH₄) flow rate may be about 40 sccm, the pressure in the reaction chamber may be in the range of 40 to 120 Pa, and the high frequency (13.56 MHz) power density may be in the range of 5 to 15 mW/cm².

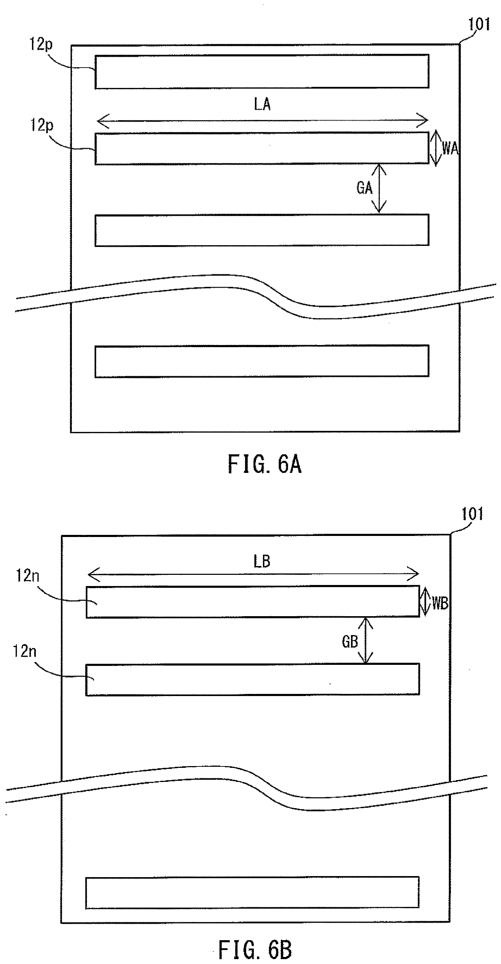

Subsequently, a shadow mask is placed on the i-type amorphous semiconductor layer 102i, and p-type amorphous semiconductor strips 102p are formed. P-type amorphous semiconductor strips formed using a shadow mask will be described below. FIG. 6A is a schematic view of example p-type amorphous semiconductor strips formed on the silicon substrate 101. As shown in FIG. 6A, each p-type amorphous semiconductor strip 102p is generally rectangular in shape and has a long side LA with a dimension of about 10 to 200 mm and a short side WA with a dimension of about 200 µm to 2 mm. The gap distance GA between adjacent p-type amorphous semiconductor strips 102p is not larger than about 2 mm. The diffusion length of carriers (i.e. electrons and positive holes) produced in the silicon substrate 101 is about 2 mm. Thus, if the diffusion length of carriers (i.e. electrons and positive holes) is not less than 2 mm, carriers disappear between p-type amorphous semiconductor strips 102p spaced apart by a gap distance GA that is larger than 2mm, decreasing photoelectric conversion efficiency; however, in the present embodiment, the gap distance GA is not larger than 2mm such that carriers do not disappear, thereby improving photoelectric conversion efficiency.

The shadow mask used may be a metal mask made of a metal such as stainless steel, copper, nickel, an alloy containing nickel (for example, SUS 430, 42 alloy, or invar), or molybdenum. Instead of such a metal mask, a mask made of glass, ceramics (for example, alumina, zirconia), or an organic film may be used. Alternatively, a mask made by etching a silicon substrate may be used. The thickness of the shadow mask is preferably about 50 to 300 µm, for example. In this case, the shadow mask is unlikely to be bent or caused to float by magnetic forces.

When the thermal expansion coefficient of the silicon substrate 101 and material costs are taken into consideration, the shadow mask is more preferably a 42 alloy. Regarding the thickness of the shadow mask, when manufacturing costs are taken into consideration, using a shadow mask only once and discarding it would be problematic. Since using a shadow mask multiple times reduces running costs of production, it is preferable to recycle a shadow mask and use it multiple times. In this case, films formed on the shadow mask should be removed using hydrofluoric acid or NaOH.

The p-type amorphous semiconductor strips 102p are formed by plasma CVD, for example. The reactant gas to be introduced into the reaction chamber of the plasma CVD equipment includes silane gas, hydrogen gas and diborane gas diluted with hydrogen (with a diborane concentration of about 2 %, for example). In this case, the hydrogen gas flow rate may be in the range of 0 to 100 sccm, the silane gas flow rate may be 40 sccm, the diborane gas flow rate may be 40 sccm, the temperature of the silicon substrate 101 may be in the range of 150 to 210 °C, the pressure in the reaction chamber may be in the range of 40 to 120 Pa, and the high frequency power density may be in the range of 5 to 15 mW/cm². Thus, p-type amorphous semiconductor strips 102p doped with boron (B) are formed.

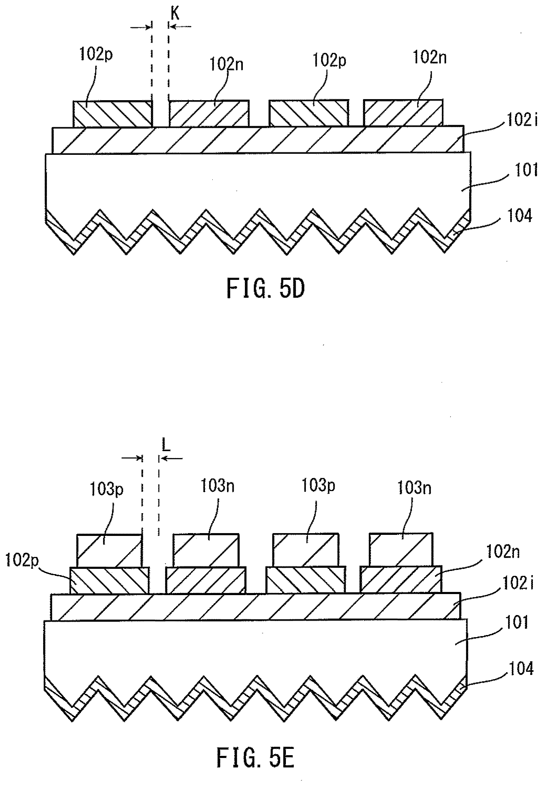

After the p-type amorphous semiconductor strips 102p are formed, n-type amorphous semiconductor strips 102n are formed as shown in FIG. 5D.

The n-type amorphous semiconductor strips 102n are formed by placing a shadow mask and using plasma CVD, for example. FIG. 6B shows a schematic view of example n-type amorphous semiconductor strips 102n formed using a shadow mask. In this drawing, the p-type amorphous semiconductor strips 102p are not shown.

As shown in FIG. 6B, each n-type amorphous semiconductor strip 102n is generally rectangular in shape and has a long side LB with a dimension of about 10 to 200 mm and a short side WB with a dimension of about 500 to 1500 µm. The gap distance GB between adjacent n-type amorphous semiconductor strips 102n is in the range of about 500 to 1500 µm.

The n-type amorphous semiconductor strips 102n may be formed by plasma CVD, for example. The reactant gas to be introduced into the reaction chamber of the plasma CVD equipment includes silane gas, hydrogen gas, and phosphine gas diluted with hydrogen (with a phosphine concentration of 1 %, for example). In this case, the temperature of the silicon substrate 101 may be about 170 °C, for example, the hydrogen gas flow rate may be in the range of 0 to 100 sccm, the silane gas flow rate may be about 40 sccm, the phosphine gas flow rate may be about 40 sccm, the pressure in the reaction chamber may be about 40 Pa, the high frequency power density may be about 8.33 mW/cm². Thus, n-type amorphous semiconductor strips 102n doped with phosphorus are formed.

The n-type amorphous semiconductor strips 102n and the p-type amorphous semiconductor strips 102p shown in FIG. 6A, formed using shadow masks, may not overlap each other or may partially overlap each other. If the n-type and p-type amorphous semiconductor strips 102n and 102p do not overlap, the p-type and n-type amorphous semiconductor strips 102p and 102n are spaced apart by the distance K, as shown in FIG. 5D. The regions between the p-type and n-type amorphous semiconductor strips 102p and 102n are passivated by the i-type amorphous semiconductor layer 102i such that very few of the carriers produced in the silicon substrate 101 disappear. If, on the other hand, the n-type and p-type amorphous semiconductor strips 102n and 102p partially overlap, overlap regions are formed in the p-type and n-type amorphous semiconductor strips 102p and 102n where they partially overlap. However, since the conductivity of the p-type and n-type amorphous semiconductor strips 102p and 102n is low, no current flows between the p-type and n-type amorphous semiconductor strips 102p and 102n, causing no short circuit in a p-n junction.

Next, after the n-type amorphous semiconductor strips 102n are formed, n-type electrodes 103n and p-type electrodes 103p are formed on the p-type amorphous semiconductor strips 102p and n-type amorphous semiconductor strips 102n, respectively, as shown in FIG. 5E.

The n-type and p-type electrodes 103n and 103p are formed by placing a shadow mask on the silicon substrate 101 and using deposition or sputtering, for example. The thickness of the n-type and p-type electrodes 103n and 103p is preferably in the range of 50 nm to 1 µm, and more preferably in the range of 50 nm to 500 nm. Increased thickness of the electrodes 103 causes larger stress on the silicon substrate 101, which may cause the silicon substrate 101 to warp.

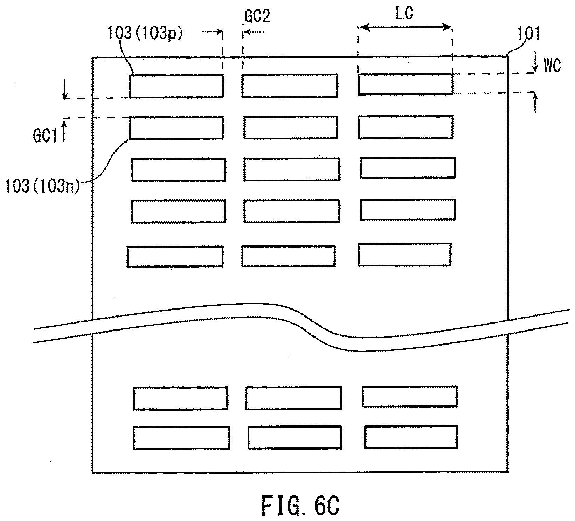

FIG. 6C is a schematic view of example electrodes 103 formed using a shadow mask. In this drawing, the p-type and n-type amorphous semiconductor strips 102p and 102n are not shown. As shown in FIG. 6C, each electrode 103 is generally rectangular in shape and has a long side LC with a dimension of about 8 to 100 mm and a short side WC with a dimension of about 500 to 1500 µm. The gap distance GC1 between electrodes 103 located adjacent in the direction of a short side WC, i.e. the gap dimension L between p-type and n-type electrodes 103p and 103n is in the range of about 100 to 300 µm. The gap distance GC2 between electrodes 103 located adjacent in the direction of a long side LC is in the range of about 100 to 1000 µm.

Each of the n-type and p-type electrodes 103n and 103p formed on the n-type and p-type amorphous semiconductor strips 102n and 102p using shadow masks is spaced apart from, and thus not electrically connected with, an electrode of the same conductivity type located adjacent in the direction of a long side, by the gap distance GC2.

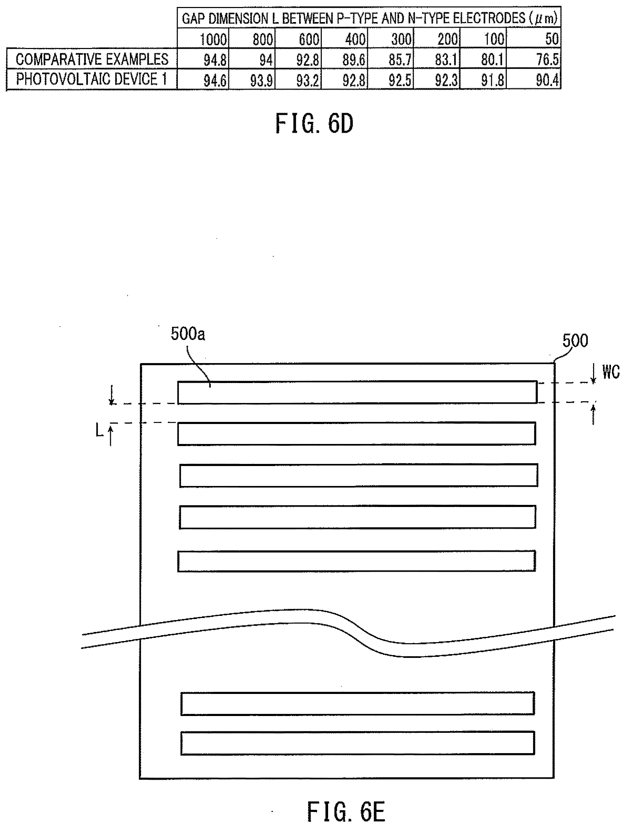

Photovoltaic devices with p-type and n-type electrodes 103p and 103n each provided for one of the p-type and n-type amorphous semiconductor strips 102p and 102n without being divided (comparative examples), and photovoltaic devices 1 with separate electrodes for each of the p-type and n-type amorphous semiconductor strips 102p and 102n (present embodiment) were fabricated; the yields of these devices are shown in FIG. 6D.

In the context of the photovoltaic devices of the comparative examples, the p-type and n-type electrodes 103p and 103n were formed using the shadow mask shown in FIG. 6E, in which the openings 500a for the p-type and n-type electrodes 103p and 103n are spaced apart from each other in the direction of a short side by the gap dimension L, and are not divided into sub-electrodes arranged in the direction of a long side. In this case, as shown in FIG. 6D, the yield rapidly decreases as the gap dimension L between the p-type and n-type electrodes 103p and 103n drops to and below 400 µm. If the gap dimension L is not larger than 400 µm, the shadow mask 500 can easily be bent by its own weight. As a result, a p-type electrode 103p designed to be formed on a p-type amorphous semiconductor strip 102p may be partially formed on an n-type amorphous semiconductor strip 102n, or, on the contrary, an n-type electrode 103n designed to be formed on an n-type amorphous semiconductor strip 102n may be partially formed on a p-type amorphous semiconductor strip 102p. This may cause a short circuit in a p-n junction, which is presumably the cause for the decrease in yield.

On the other hand, in the photovoltaic device 1 in the present embodiment, the yield hardly decreases even when the gap dimension L is not larger than 400 µm, unlike in the comparative examples. In the present embodiment, the electrodes 103 formed using a shadow mask are divided into sub-electrodes arranged in the direction of a long side such that the regions between the electrodes 103 located adjacent in the direction of a long side prevent the shadow mask to bend. As a result, the p-type and n-type electrodes 103p and 103n are located on the p-type and n-type amorphous semiconductor strips 102p and 102n, respectively, and are not located on amorphous semiconductor strips of the wrong conductivities.

Thus, in the photovoltaic device 1 in the present embodiment, the p-type and n-type electrodes 103p and 103n are formed using a shadow mask, thereby improving positional accuracy for the p-type and n-type electrodes 103p and 103n over the comparative examples, reducing the decrease in yield. Particularly, if a yield of 90 % is desired, the gap dimension L for the p-type and n-type electrodes 103p and 103n is preferably not more than 400 µm.

The above method allows the p-type and n-type electrodes 103p and 103n to be formed all at the same time, which enables fabricating the photovoltaic device 1 at low costs. Further, the p-type and n-type electrodes 103p and 103n are divided into sub-electrodes arranged in the longitudinal direction, thereby improving yield.

The electrodes 103 are not limited to the pattern shown in FIG. 6C and it is only required that, for a given row, two or more separate electrodes 103 be arranged in the longitudinal direction, spaced apart by a predetermined distance. If only one continuous electrode 103 is provided for a given row, a large stress is applied to the electrode 103, causing the silicon substrate 101 of the photovoltaic device 1 to warp significantly. Providing separate electrodes 103 arranged in the longitudinal direction mitigates the stress on the electrodes 103.

The electrodes 103 may have different dimensions as measured in the longitudinal direction. The electrodes 103 have stresses; if the length of the electrodes 103 near the edges of the silicon substrate 101 is larger than that of the electrodes 103 near the center of the silicon substrate 101, the stress on the electrodes 103 near the center can be mitigated, thereby preventing the silicon substrate 101 from warping. Further, if the length of the electrodes 103 near the center of the silicon substrate 101 is larger than that of the electrodes 103 near the edges of the silicon substrate 101, light confinement efficiency is higher, thereby improving the performance of the photovoltaic device 1.

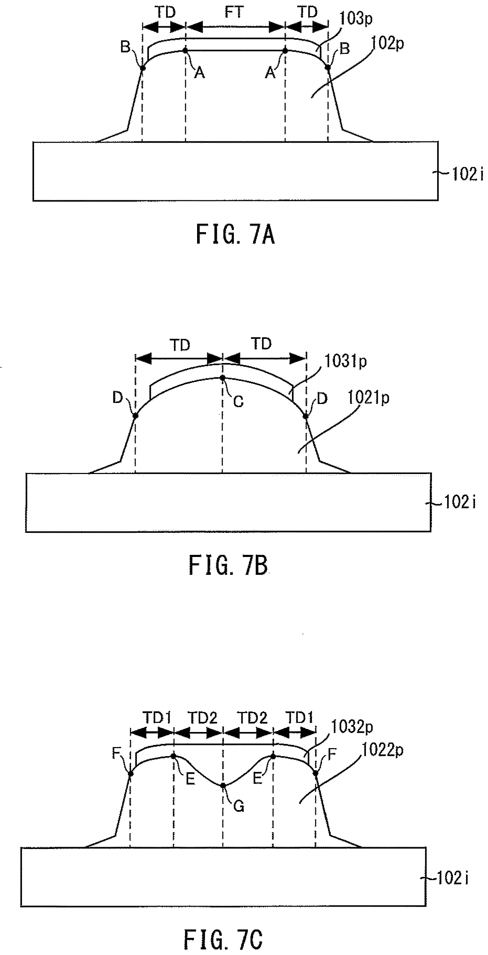

In the present embodiment, for example, a p-type amorphous semiconductor strip 102p may have the cross-section shown in FIG. 7A. Referring to FIG. 7A, as traced along an in-plane direction of the p-type amorphous semiconductor strip 102p, the p-type amorphous semiconductor strip 102p has a flat region FT and reduced-thickness regions TD. The flat region FT has the maximum thickness of the p-type amorphous semiconductor strip 102p and has a substantially constant thickness. While FIG. 7A shows a p-type amorphous semiconductor strip 102p, the embodiment of the present invention only requires that at least one of the group of p-type amorphous semiconductor strips 102p and the group of n-type amorphous semiconductor strips has reduced-thickness regions.

The reduced-thickness regions TD are defined by the points A and points B as measured along an in-plane direction of the p-type amorphous semiconductor strip 102p, where the points A are the ends of the flat region FT and the points B are the points at which the decreasing rate of the film thickness changes from a first decreasing rate to a second decreasing rate that is larger than the first decreasing rate.

The reduced-thickness regions TD are located on both sides of the flat region FT as traced along an in-plane direction of the p-type amorphous semiconductor strip 102p.

The p-type amorphous semiconductor strip 102p has reduced-thickness regions TD because the p-type amorphous semiconductor strip 102p is formed by plasma CVD using a shadow mask. The reduced-thickness regions TD have smaller thicknesses than the flat region FT, and thus the dopant concentration in the reduced-thickness regions TD is higher than that for the flat region FT.

Then, an electrode 103p is positioned to contact the entire flat region FT and portions of the reduced-thickness regions TD of the p-type amorphous semiconductor strip 102p.

The n-type amorphous semiconductor strips 102n may have the same structure as the p-type amorphous semiconductor strips 102p. In such cases, an n-type electrode 103n is positioned to contact the entire flat region FT and portions of the reduced-thickness regions TD of an n-type amorphous semiconductor strip 102n.

As a result, the resistance encountered by carriers (i.e. electrons) as they move through a p-type amorphous semiconductor strip 102p to a p-type electrode 103p is smaller than in implementations where a p-type amorphous semiconductor strip 102p has a constant thickness as traced along an in-plane direction of the i-type amorphous semiconductor layer 102i. Further, the resistance encountered by carriers (i.e. positive holes) as they move through an n-type amorphous semiconductor strip 102n to an n-type electrode 103n is smaller than in implementations where an n-type amorphous semiconductor strip 102n has a constant thickness as traced along an in-plane direction of the i-type amorphous semiconductor layer 102i. This improves the conversion efficiency of the photovoltaic device 1.

Alternatively, a p-type electrode 103p may contact the entire reduced-thickness regions TD of a p-type amorphous semiconductor strip 102p, and an n-type electrode 103n may contact the entire reduced-thickness regions TD of an n-type amorphous semiconductor strip 102n.

Instead of the cross-section shown in FIG. 7A, a p-type amorphous semiconductor strip 102p may have the cross-section shown in FIG. 7B, for example. Referring to FIG. 7B, the photovoltaic device 1 may include p-type amorphous semiconductor strips 1021p instead of the p-type amorphous semiconductor strips 102p, and include p-type electrodes 1031p instead of the p-type electrodes 103p.

It is assumed that, for a given p-type amorphous semiconductor strip 1021p, the point C is the point with the maximum film thickness and the points D are the points at which the decreasing rate of the film thickness changes from a first decreasing rate to a second decreasing rate that is larger than the first decreasing rate. Then, the reduced-thickness regions TD are the regions beginning at the point C and ending at the points D as traced along an in-plane direction of the p-type amorphous semiconductor strip 1021p.

The p-type amorphous semiconductor strip 1021p has two reduced-thickness regions TD as traced along an in-plane direction of the p-type amorphous semiconductor strip 1021p. The two reduced-thickness regions TD are arranged in an in-plane direction of the p-type amorphous semiconductor strip 1021p to be in contact with each other.

A p-type electrode 1031p is positioned to contact a portion of one reduced-thickness region TD and a portion of the other reduced-thickness region TD.

The photovoltaic device 1 may include, instead of the n-type amorphous semiconductor strips 102n, n-type amorphous semiconductor strips having the same structure as the p-type amorphous semiconductor strip 1021p shown in FIG. 7B.

By providing this construction, the resistance encountered by carriers (i.e. electrons) as they move through a p-type amorphous semiconductor strip 1021p to a p-type electrode 1031p is smaller than in implementations where a p-type amorphous semiconductor strip has a constant thickness as traced along an in-plane direction of the i-type amorphous semiconductor layer 102i. Further, the resistance encountered by carriers (i.e. positive holes) as they move through an n-type amorphous semiconductor strip having the same structure as the p-type amorphous semiconductor strip 1021p to an n-type electrode is smaller than in implementations where an n-type amorphous semiconductor strip has a constant thickness as traced along an in-plane direction of the i-type amorphous semiconductor layer 102i. This improves the conversion efficiency of the photovoltaic device 1.

Alternatively, the p-type electrode 1031p may be positioned to contact the two entire reduced-thickness regions TD of the p-type amorphous semiconductor strip 1021p, and such a construction also applies to the n-type amorphous semiconductor strips having the same structure as the p-type amorphous semiconductor strip 1021p.

Alternatively, the p-type amorphous semiconductor strip 102p may have, for example, the cross-section shown in FIG. 7C, instead of the cross-section shown in FIG. 7A. Referring to FIG. 7C, the photovoltaic device 1 may include p-type amorphous semiconductor strips 1022p instead of the p-type amorphous semiconductor strips 102p, and p-type electrodes 1032p instead of the p-type electrodes 103p.

It is assumed that, for a given p-type amorphous semiconductor strip 1022p, the points E are the points with the maximum film thickness, the points F are the points at which the decreasing rate of the film thickness changes from a first decreasing rate to a second decreasing rate that is larger than the first decreasing rate, and the point G is the point at which the value of the decreasing rate of the film thickness changes from negative to positive. Then, the reduced-thickness regions TD1 are defined by the points E and F as measured along an in-plane direction of the p-type amorphous semiconductor strip 1022p, and the reduced-thickness regions TD2 are defined by the points E and G as measured along an in-plane direction of the p-type amorphous semiconductor strip 1022p.

Thus, the p-type amorphous semiconductor strip 1022p has two reduced-thickness regions TD1 and two reduced-thickness regions TD2 as traced along an in-plane direction of the p-type amorphous semiconductor strip 1022p.

The two reduced-thickness regions TD2 are disposed such that the thickness distribution is symmetrical, as measured in an in-plane direction of the p-type amorphous semiconductor strip 1022p, with respect to the line running through the point G. The two reduced-thickness regions TD1 are located on the both sides of the combination of two reduced-thickness regions TD2 as traced along an in-plane direction of the p-type amorphous semiconductor strip 1022p.

A p-type electrode 1032p is positioned to contact the two entire reduced-thickness regions TD2 and a portion of one reduced-thickness region TD1 and a portion of the other reduced-thickness region TD1.

The photovoltaic device 1 may include, instead of the n-type amorphous semiconductor strips 102n, n-type amorphous semiconductor strips having the same structure as the p-type amorphous semiconductor strip 1022p shown in FIG. 7C.

By providing this construction, the resistance encountered by carriers (i.e. electrons) as they move through an n-type amorphous semiconductor strip to an n-type electrode is smaller than in implementations where an n-type amorphous semiconductor strip has a constant thickness as traced along an in-plane direction of the i-type amorphous semiconductor layer 102i. Further, the resistance encountered by carriers (i.e. positive holes) as they move through a p-type amorphous semiconductor strip 1022p to a p-type electrode 1032p is smaller than in implementations where an n-type amorphous semiconductor strip has a constant thickness as traced along an in-plane direction of the i-type amorphous semiconductor layer 102i. This improves the conversion efficiency of the photovoltaic device 1.

Alternatively, the p-type electrode 1032p may be positioned to contact the two entire reduced-thickness regions TD1 and two entire reduced-thickness regions TD2 of the p-type amorphous semiconductor strip 1022p, and such a construction also applies to the n-type amorphous semiconductor strips having the same structure as the p-type amorphous semiconductor strip 1022p.

Thus, the photovoltaic device 1 includes p-type amorphous semiconductor strips and n-type amorphous semiconductor strips each having reduced-thickness regions TD (or TD1 and TD2). In embodiments of the present invention, each reduced-thickness region is constituted by one of the reduced-thickness regions TD, TD1 and TD2.

Thus, a reduced-thickness region is defined by a first point and a second point as measured along an in-plane direction of a p-type amorphous semiconductor strip or n-type amorphous semiconductor strip, where the first point is the point on the p-type or n-type amorphous semiconductor strip with the maximum film thickness, and the second point is the point on the p-type or n-type amorphous semiconductor strip as measured along an in-plane direction at which the decreasing rate of the film thickness changes from a first decreasing rate to a second decreasing rate that is larger than the first decreasing rate or the value of the decreasing rate of the film thickness changes from negative to positive.

The above examples describe implementations where the surface of the silicon substrate 101 is flat; however, in reality, the face of the silicon substrate 101 that has no texture may also have irregularities with a size of about 1 µm produced by the etching for removing the damaged layer, for example. A method of measuring the thickness of an amorphous semiconductor layer on a silicon substrate 101 with irregularities on its surface will be described below.

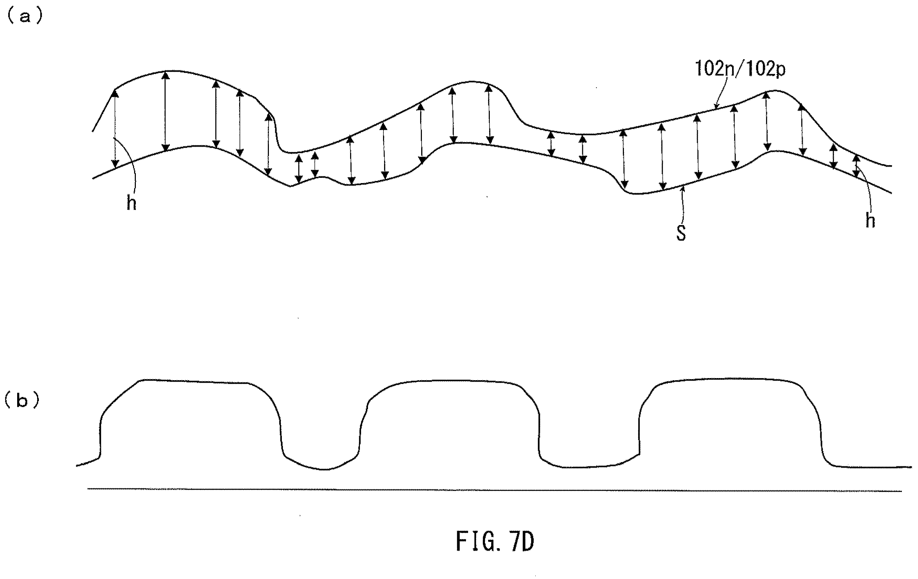

On a silicon substrate 101 with irregularities on its surface is formed an i-type amorphous semiconductor layer 102i, after which n-type amorphous semiconductor strips 102n and p-type amorphous semiconductor strips 102p having reduced-thickness regions are formed on the i-type amorphous semiconductor layer 102i. Then, scanning electron microscopy (SEM) or transmission electron microscopy (TEM) is used to take a picture of a cross-section of the silicon substrate 101. An interface between the i-type amorphous semiconductor layer 102i and silicon substrate 101 can be easily observed in this picture. FIG. 7D(a) schematically illustrates measurements of the film thickness h, i.e. the distance between the interface S between the i-type amorphous semiconductor layer 102i and the surface of the silicon substrate 101 to the surface of an n-type amorphous semiconductor strip 102n or p-type amorphous semiconductor strip 102p. The values of the film thickness h shown in FIG. 7D(a) can be plotted to represent the values of film thickness h of FIG. 7D(a) as shown in FIG. 7D(b). That is, the thickness of an amorphous semiconductor layer (i.e. n-type or p-type amorphous semiconductor strip) may be identified assuming that the surface of the silicon substrate 101 is generally flat.

In implementations where both faces of a silicon substrate 101 have a texture, the film thickness above the texture may be measured and its values may be plotted in a manner similar to that described above to enable determining a reduced-thickness region.

The face of a silicon wafer that has no texture has a difference in height of about 2 µm at most; still, it has very small differences in height compared with the face with a texture (having a difference in height of several tens of µm at the largest), and is substantially flat.

Thus, when the easiness with which contact can be made to external wiring such as a wiring sheet 300 and the difficulty with which a short circuit can occur between electrodes 103 are considered, normally, the i-type amorphous semiconductor layer 102i and n-type and p-type amorphous semiconductor strips 102n and 102p, for example, would preferably be formed on a back face (i.e. face without a texture) which is relatively flat. However, to trap incident light efficiently in the silicon substrate 101, the back face of the silicon substrate 101 preferably has a texture, and, if the back face of the silicon substrate 101 has a texture, the surface area of the silicon substrate 101 increases (by about 1.7 times), thereby reducing contact resistance. Further, if only one face of the silicon substrate 101 is to have a texture, the anisotropic etching needs to include a step for protecting the face that is not to have a texture. On the other hand, if both faces of the silicon substrate 101 are to have a texture, none of the faces of the silicon substrate 101 needs to be protected, thereby reducing the number of steps for the process.

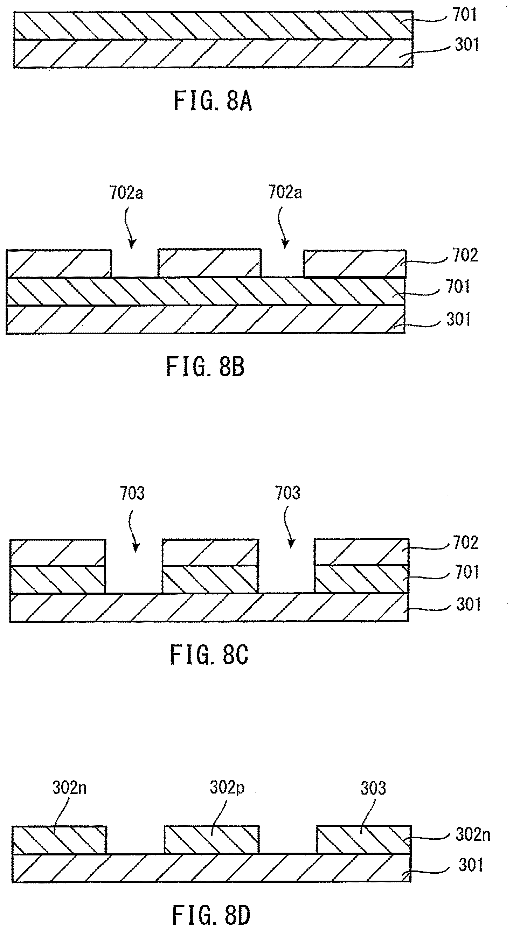

Now, an example method of manufacturing the wiring sheet 300 will be described with reference to FIGS. 8A to 8D. As shown in FIG. 8A, a conductive layer 701 is formed on the surface of an insulating substrate 301. The insulating substrate 301 may be made of a resin such as polyester, polyethylene naphthalate or polyimide. The thickness of the insulating substrate 301 may be, for example, not smaller than 10 µm and smaller than 200 µm, where the particularly preferable thickness is about 25 µm. The conductive layer 701 may be made of a metal such as copper, for example; however, it is not limited thereto.

Subsequently, as shown in FIG. 8B, a resist pattern 702 is formed on the conductive layer 701 on the insulating substrate 301. The resist pattern 702 has openings 702a in the areas other than those where n-type wiring member 302n, a p-type wiring member 302p and connection wiring for connecting the n-type and p-type wiring members 302n and 302p are to be formed. The resist pattern 702 may be made of a known material, for example, and may be formed by a method such as screen printing, dispenser coating or ink jet printing.

Next, as shown in FIG. 8C, the portions of the conductive layer 701 that are not covered by the resist pattern 702 are removed by wet etching, for example, to pattern the conductive layer 701, thereby forming openings 703. Then, the resist 702 on the conductive layer 701 is removed to form the n-type wiring member 302n, p-type wiring member 302p and connection wiring 303, as shown in FIG. 8D, thereby producing the wiring sheet 300 shown in FIG. 3.

The n-type electrodes 103n and p-type electrodes 103p of the photovoltaic device 1 shown in FIG. 1 are joined to the n-type wiring member 302n and p-type wiring member 302p, respectively, of the wiring sheet 300.

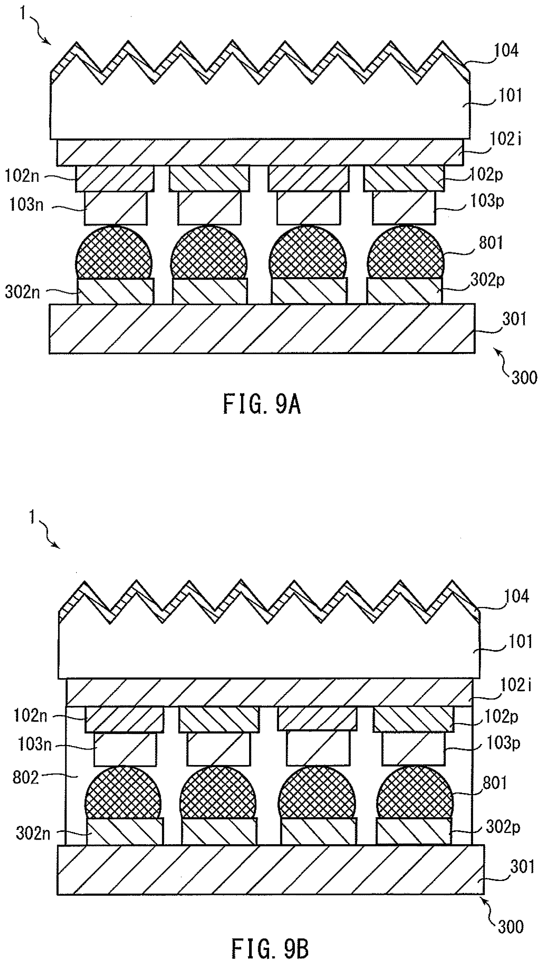

FIG. 9A is a schematic cross-sectional view of the wiring sheet 300 and the photovoltaic device 1 to be joined together. The n-type and p-type wiring members 302n and 302p are bonded to the n-type and p-type electrodes 103n and 103p via pieces of a solder resin 801. Further, as shown in FIG. 9B, the p-type and n-type wiring members 302p and 302n on the wiring sheet 300 may be bonded to the p-type and n-type electrodes 103p and 103n via pieces of a solder resin 801 and an insulating resin 802 to improve insulation, thereby increasing the reliability of the photovoltaic device 1.

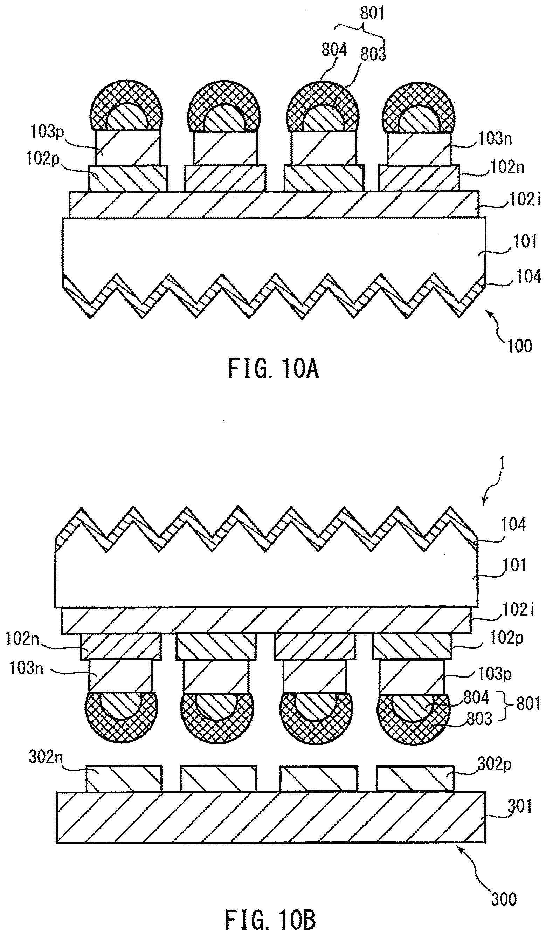

More specifically, as shown in FIG. 10A, pieces of a solder resin 801 are provided on the surfaces of the n-type and p-type electrodes 103n and 103p of the photovoltaic device 1. The solder resin 801 is formed by dispersing a conductive adhesive 804 in an insulating adhesive 803. The solder resin 801 may be, for example, TCAP-5401-27 from Tamura Kaken Corporation.

The insulating adhesive 803 may be, for example, an epoxy resin, acrylic resin or urethane resin, or may be a thermosetting and/or photocurable insulating resin containing one of them as its resin component.

The conductive adhesive 804 may be made of solder particles containing at least one of tin and bismuth, for example. More preferably, it may be an alloy of tin and bismuth, indium, silver or the like. This composition reduces the melting point of the solder, which means that the heating temperature during the step of curing after the melting of the conductive adhesive 804, discussed below, can be reduced, thereby preventing the photovoltaic device 1 from warping.

Solder resin 801 pieces are positioned on the surfaces of the n-type and p-type electrodes 103n and 103p using, for example, screen printing, dispenser coating or ink jet printing. Particularly, screen printing is preferable since it allows solder resin 801 pieces to be disposed in a simple manner at low costs and requires a short period of time. The present embodiment describes an implementation where solder resin 801 pieces are provided on the n-type and p-type electrodes 103n and 103p of the photovoltaic device 1. Alternatively, for example, solder resin 801 pieces may be provided on connection wiring (not shown) for connecting the n-type and p-type wiring members 302n and 302p of the wiring sheet 300, or solder resin 801 pieces may be provided on all of the n-type and p-type electrodes 103n and 103p and connection wiring. Further, while the present embodiment describes an implementation using the solder resin 801, the solder resin 801 may be replaced by a solder paste (i.e. flux with solder particles dispersed therein). In such cases, too, it is preferable to use a solder with a low melting point.

If the photovoltaic device 1 includes alignment marks, it is preferable that the conductive adhesive 804 is not located on the alignment marks. This prevents the conductive adhesive 804 flowing out of the alignment marks from decreasing the recognition accuracy of the alignment marks. Further, during the step of placing the photovoltaic device 1 and wiring sheet 300 on each other, it is possible to align the photovoltaic device 1 with the wiring sheet 300 more accurately.

Next, as shown in FIG. 10B, the n-type and p-type electrodes 103n and 103p of the photovoltaic device 1 are aligned with the n-type and p-type wiring members 302n and 302p of the wiring sheet 300 such that the electrodes face the wiring members. At this time, an insulating resin is provided between the regions of the photovoltaic device 1 that are other than the n-type and p-type electrodes 103n and 103p and the regions of the wiring sheet 300 that are other than the n-type and p-type wiring members 302n and 302p. This prevents the solder resin 801 from flowing through the insulating resin to a space between electrodes 103 on the photovoltaic device 1 or a space between n-type and p-type wiring members 302n and 302p on the wiring sheet 300, thereby preventing a short circuit between electrodes 103 or between n-type and p-type wiring members 302n and 302p.

If the photovoltaic device 1 includes alignment marks, it is preferable to place the photovoltaic device 1 and wiring sheet 300 on each other such that the alignment marks face predetermined regions in the wiring sheet 300. At this stage, the insulating resin has not been cured, which makes it easy to position the photovoltaic device 1 and wiring sheet 300 relative to each other. This improves the reliability of the electrical and mechanical connection between the n-type and p-type electrodes 103n and 103p and the n-type and p-type wiring members 302n and 302p of the wiring sheet 300.

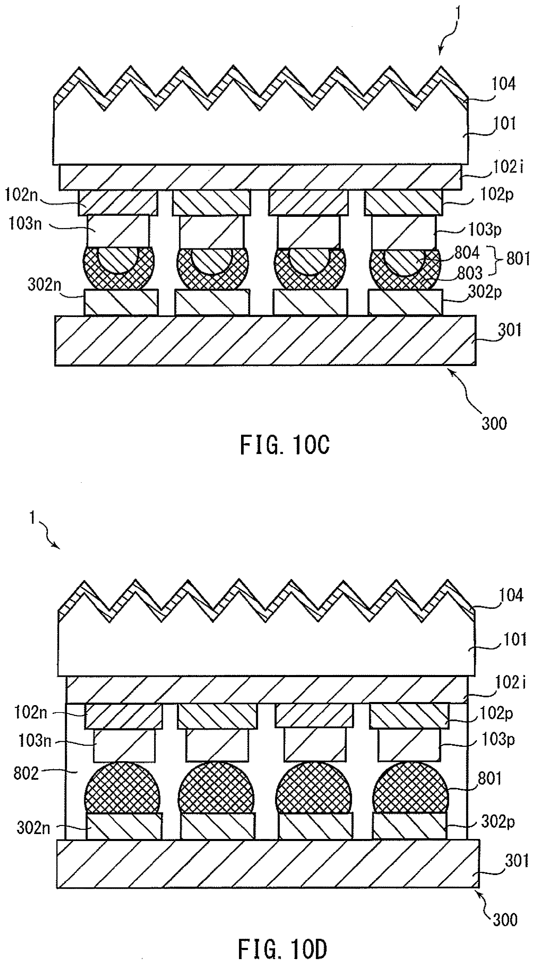

As shown in FIG. 10C, after the photovoltaic device 1 and wiring sheet 300 are placed on each other, the insulating resin is cured. This results in a cured insulating resin. The insulating resin may be cured by, for example, heating the insulating resin or illuminating it with light such as ultraviolet light, or heating it and illuminating it with ultraviolet light. At this stage, the insulating resin does not have to be completely cured, but needs to be cured to such a degree that, during the curing step after the conductive adhesive 804 is melt as discussed below, it does not mix with the melt conductive adhesive 804.

Subsequently, the conductive adhesive 804 is melt and then the conductive adhesive 804 is cured. The melt conductive adhesive 804 may be cured by, for example, pressurizing the photovoltaic device 1 and wiring sheet 300 and heating the solder resin 801 to melt the conductive adhesive 804 in the solder resin 801 and then cooling the conductive adhesive 804.

The melt conductive adhesive 804 condenses between at least some portions of the surfaces of the n-type electrodes 102n and at least some portions of the surfaces of the n-type wiring member 302n of the wiring sheet 300 and condenses between at least some portions of the surfaces of the p-type electrodes 103p and at least some portions of the surfaces of the p-type wiring member 302p of the wiring sheet 300. Thereafter, as the melt conductive adhesive 804 is cooled, it solidifies in the state in which it has condensed. Further, as the solder resin 801 is heated, the viscosity of the insulating adhesive 803 decreases and the adhesive moves to the spaces between the electrodes 103 and between the n-type and p-type wiring members 302n and 302p of the wiring sheet 300. Thereafter, the insulating adhesive 803 is further heated so as to be cured in the positions to which it has moved. As the solder resin 801 is heated, the insulating resin is also heated and is completely cured. This produces a photovoltaic device 1A with the photovoltaic device 1 joined to the wiring sheet 300, as shown in FIG. 10D.

In the photovoltaic device 1 in the first embodiment described above, a plurality of separate electrodes 103 (i.e. n-type electrodes 103n and p-type electrodes 103p) are located on each of the n-type amorphous semiconductor strips 102n and p-type amorphous semiconductor strips 102p and spaced apart from each other. The electrodes 103 are formed using a shadow mask. Since this shadow mask is configured to form separate electrodes 103 (103n and 103p) spaced apart from each other, the shadow mask is less likely to bend than in implementations where a shadow mask for forming electrodes 103 that are not separated in this manner is used. Thus, even if the gap dimension between n-type and p-type electrodes 103n and 103p is reduced, the n-type and p-type electrodes 103n and 103p are not likely to be partially located on semiconductor strips of the wrong conductivities. As such, n-type and p-type electrodes 103n and 103p having a desired geometry are positioned on the n-type and p-type amorphous semiconductor strips 102n and 102p, thereby preventing an electrical short circuit in a p-n junction, reducing the decrease in yield.

Further, in the first embodiment described above, the n-type electrodes 103n spaced apart from each other are connected via the n-type wiring member 302n of the wiring sheet 300, and the p-type electrodes 103p spaced apart from each other are connected via the p-type wiring member 302p of the wiring sheet 300. Thus, a current produced as light enters the light-receiving face of the photovoltaic device 1 can be taken out toward the outside via the wiring sheet 300.

In the photovoltaic device 1 described above, the light-receiving face and back face of the silicon substrate 101 are not mirror images of each other, and thus a large stress is applied to the silicon substrate 101 at the stage where the p-type and n-type amorphous semiconductor strips 102p and 102n have been formed. Further, as electrodes 103 are formed on the p-type and n-type amorphous semiconductor strips 102p and 102n, the stress on the silicon substrate 101 further increases. The larger the thickness of the electrodes 103, the larger the stress; since the wiring sheet 300 is joined to the photovoltaic device 1, the thickness of the electrodes 103 on the p-type and n-type amorphous semiconductor strips 102p and 102n can be reduced to some degree; in the present embodiment, further, a shadow mask is used to form separate electrodes 103 spaced apart from each other. Thus, the shadow mask is less likely to bend than in implementations with rectangular electrodes 103 with a large aspect ratio, reducing the stress on the silicon substrate 101.

### <Second Embodiment>

The first embodiment described above describes an implementation where an i-type amorphous semiconductor layer 102i is formed on the entire back face of the silicon substrate 101 and then p-type amorphous semiconductor strips 102p are formed on the i-type amorphous semiconductor layer 102i and then n-type amorphous semiconductor strips 102n are formed; however, the formation of the p-type and n-type amorphous semiconductor strips 102p and 102n is not limited to this order.

For example, referring to FIG. 5C, after the i-type amorphous semiconductor layer 102i is formed, n-type amorphous semiconductor strips 102n as shown in FIG. 6B may be formed on the i-type amorphous semiconductor layer 102i using a shadow mask, and then p-type amorphous semiconductor strips 102p as shown in FIG. 6A may be formed on the i-type amorphous semiconductor layer 102i using a shadow mask.

### <Third Embodiment>

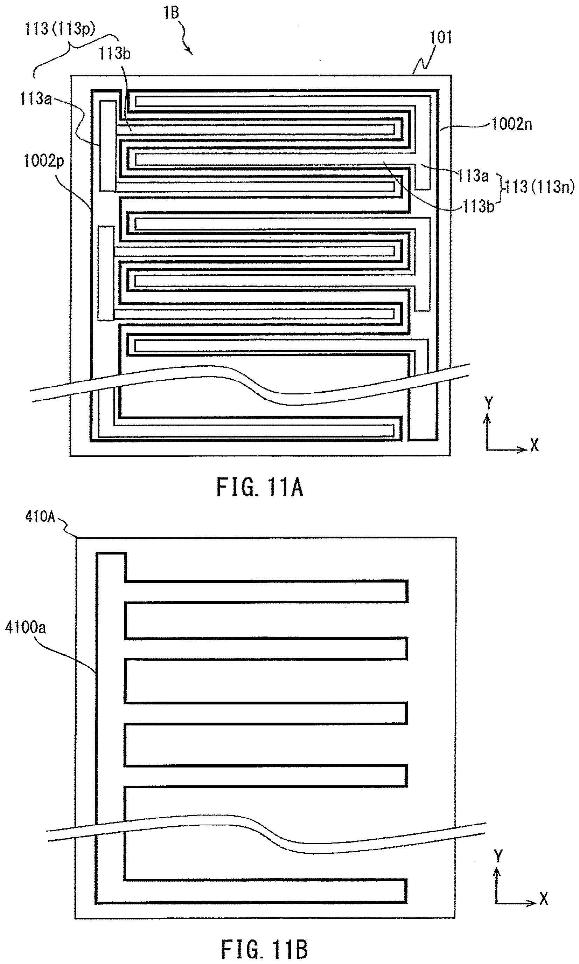

FIG. 11A is a schematic plan view of a photovoltaic device in the present embodiment. In FIG. 11A, the same components as in the first embodiment are labeled with the same characters as in the first embodiment.

As shown in FIG. 11A, the photovoltaic device 1B includes a comb-shaped n-type amorphous semiconductor strip 1002n and a comb-shaped p-type amorphous semiconductor strip 1002p. A plurality of electrodes 113 are provided on each of the n-type and p-type amorphous semiconductor strips 1002n and 1002p.

Each of the electrodes 113 includes a generally rectangular electrode grid 113a and electrode fingers 113b. The electrode grid 113a extends generally in the Y-direction of the silicon substrate 101, and the electrode fingers 113b extend generally in the X-direction of the silicon substrate 101. Each electrode grid 113a is located on the n-type or p-type amorphous semiconductor strip 1002n or 1002p and is spaced apart from the other electrode grids 113a. The electrode fingers 113b for each electrode grid 113a are in contact with one side of this grid. The electrode fingers 113b on the n-type amorphous semiconductor strip 1002n and the electrode fingers 113b on the p-type amorphous semiconductor strip 1002p are located adjacent to each other in an in-plane direction of the silicon substrate 101 in an alternate manner.

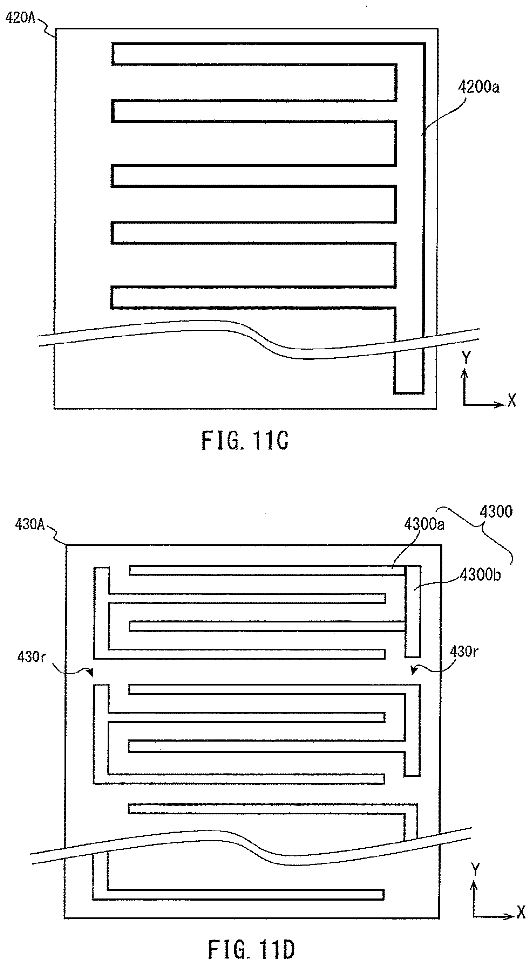

To make the photovoltaic device 1B in the present embodiment, for example, during the step shown in FIG. 5C discussed above, the shadow mask 410A shown in FIG. 11B is used to form a p-type amorphous semiconductor strip 1002p. The shadow mask 410A shown in FIG. 11B has an opening 4100a positioned to form a p-type amorphous semiconductor strip 1002p. Subsequently, after the p-type amorphous semiconductor strip 1002p is formed, the shadow mask 420A shown in FIG. 11C is used to form an n-type amorphous semiconductor strip 1002n. The shadow mask 420A shown in FIG. 11C has an opening 4200a positioned to form an n-type amorphous semiconductor strip 1002n.

Then, after the p-type and n-type amorphous semiconductor strips 1002p and 1002n are formed, for example, the shadow mask 430A shown in FIG. 11D is used to form electrodes 113. The shadow mask 430A shown in FIG. 11D have openings 4300 (4300a and 4300b) positioned to form electrodes 113 (i.e. electrode grids 113a and electrode fingers 113b). The regions 430r of the shadow mask 430A that are located between the openings 4300a are made of the same metal that forms the shadow mask 430A. In implementations where no region 430r is provided in a shadow mask, that is, not separate electrode grids 113a but a continuous electrode grid is provided, the shadow mask can easily bend due to its own weight. Further, when such a shadow mask is used repeatedly and thus the mechanical strength of the shadow mask decreases, it can bend even more easily. In the present embodiment, the regions 430r between the openings 4300a in the shadow mask 430A increases the mechanical strength of the shadow mask 430A such that the shadow mask 430A is likely to bend to a smaller degree even if the shadow mask 430A is used repeatedly.

In this implementation, a wiring sheet having a geometry analogous to that of the electrodes 113 is used and is joined to the photovoltaic device 1B. Thus, the electrode grids 113a on the n-type amorphous semiconductor strip 1002n are electrically connected via the wiring sheet and the electrode grids 113a on the p-type amorphous semiconductor strip 1002p are electrically connected via the wiring sheet such that a current produced by the photovoltaic device 1B can be taken out toward the outside via the wiring sheet.

In this implementation, the amorphous semiconductor strips (1002n and 1002p) under the electrode grids 113a may be separate ones spaced apart in a manner similar to that for the electrode grids 113a. This construction makes the shadow mask less likely to bend than in implementations where the shadow mask has openings for continuous amorphous semiconductor strips (1002n and 1002p) overlying the electrode grids 113a as shown in FIGS. 11B and 11C, thereby allowing the amorphous semiconductor strips to be formed in appropriate positions.

### <Fourth Embodiment>

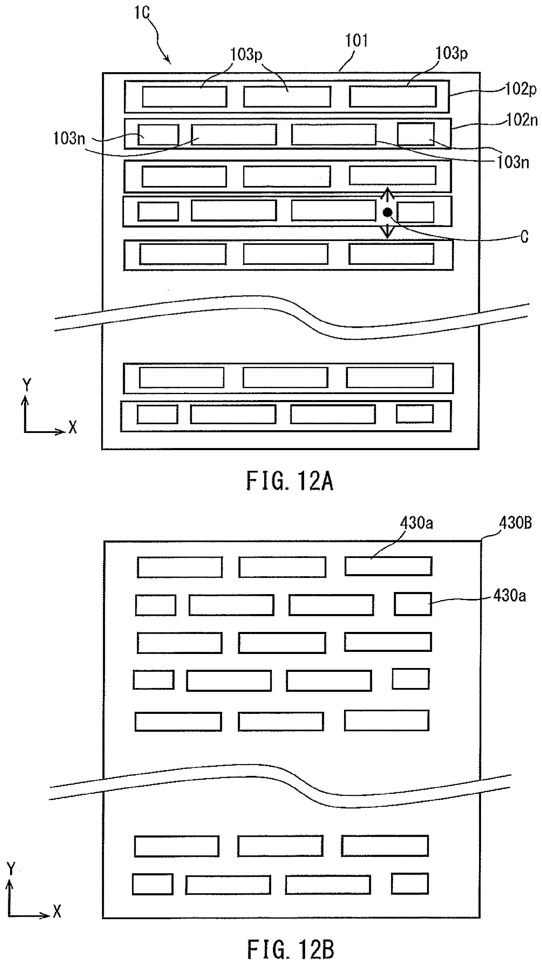

FIG. 12A is a schematic plan view of a photovoltaic device in the present embodiment. In FIG. 12A, the same components as in the first embodiment are labeled with the same characters as in the first embodiment.

As shown in FIG. 12A, the photovoltaic device 1C includes a plurality of n-type electrodes 103n and a plurality of p-type electrodes 103p on n-type amorphous semiconductor strips 102n and p-type amorphous semiconductor strips 102p. Each of the n-type electrodes 103n and p-type electrodes 103p is spaced apart from other electrodes of the same conductivity type located adjacent to itself.

In FIG. 12A, three p-type electrodes 103p with substantially the same size are provided on each p-type amorphous semiconductor strip 102p. Four n-type electrodes 103n are provided on each n-type amorphous semiconductor strip 102n. The n-type electrodes 103n other than the n-type electrodes 103n located at the ends of the row have a long side with a dimension that is substantially equal to that for a p-type electrode 103p, while the n-type electrodes 103n at the ends of the row have a long side with a dimension that is smaller than that for a p-type electrode 103. That is, the n-type electrodes 103n on an n-type amorphous semiconductor strip 102n have long sides with different dimensions. Further, the n-type electrodes 103n other than those at the ends of an n-type amorphous semiconductor strip 102n are located at positions corresponding to the positions between the p-type electrodes 103p such that their positions in the X-direction are displaced from those of the p-type electrodes 103p in the adjacent rows.

In this implementation, for example, the electrodes 103n and 103p are formed using the shadow mask 430B shown in FIG. 12B. The shadow mask 430B has openings 430a positioned to form n-type and p-type electrodes 103n and 103p. In the shadow mask used to from the electrodes 103 in the first embodiment, the short sides of the n-type and p-type electrodes 103n and 103p are aligned, and thus the smaller the distance between the n-type and p-type electrodes 103n and 103p, the more likely the shadow mask is to bend. In contrast, in the shadow mask 430B in the present embodiment, the openings 430a are not aligned, as shown in FIG. 12B. Thus, the shadow mask 430B has a higher mechanical strength than that in the first embodiment. As such, the number of times the shadow mask 430B can be used is larger than that for the shadow mask 430, thereby reducing manufacturing costs of the photovoltaic device.

Further, as shown in FIG. 12A, a carrier may be produced at the point C on the silicon substrate 101, for example; since electrodes 103 (103n and 103p) are provided in the direction of any of 360 degrees around the point C, the carrier can be easily be drawn by one of the electrodes 103, which means improved photoelectric conversion efficiency.

### <Fifth Embodiment>

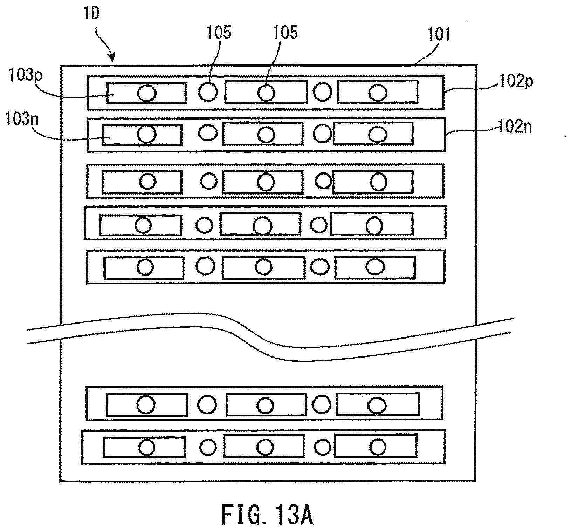

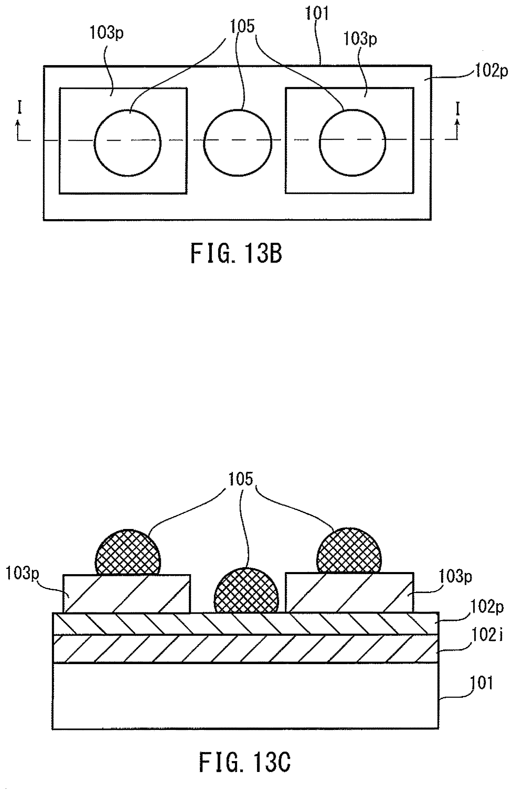

FIG. 13A is a schematic plan view of a photovoltaic device in the present embodiment. FIG. 13B is an enlarged view of a portion of the photovoltaic device 1D of FIG. 13A, and FIG. 13C is a cross-sectional view of the portion of the photovoltaic device 1D shown in FIG. 13C taken along line I-I. FIGS. 13B and 13C show some of the p-type electrodes 103p on the associated p-type amorphous semiconductor strips 102p; however, such a construction also applies to the n-type electrodes 103n on the n-type amorphous semiconductor strips 102n. In FIGS. 13A to 13C, the same components as in the first embodiment are labeled with the same characters as in the first embodiment.

As shown in FIGS. 13A to 13C, in the photovoltaic device 1D, n-type electrodes 103n and p-type electrodes 103p are provided on n-type amorphous semiconductor strips 102n and p-type amorphous semiconductor strips 102p, respectively. As in the first embodiment, each of the n-type and p-type electrodes 103n and 103p is spaced apart from electrodes of the same conductivity type located adjacent to itself.

As shown in FIGS. 13B and 13C, pieces of a metal paste 105 are provided on the p-type electrodes 103p. Further, metal paste 105 pieces are provided between the p-type electrodes 103p. The metal paste 105 may be made of silver, for example, or may be a solder resin. Although not shown in FIGS. 13B and 13C, metal paste 105 pieces are provided in a similar manner on the n-type amorphous semiconductor strips 102n and between the n-type electrodes 103n.

As the photovoltaic device 1D is joined to the wiring sheet 300, a current produced by the photovoltaic device 1D can be taken out via the metal paste 105 pieces on the n-type and p-type electrodes 103n and 103p and can be taken out via the metal paste 105 pieces provided between the n-type electrodes 103n and between the p-type electrodes 103p. This improves the fill factor (FF) of the photovoltaic device 1D.

### <Sixth Embodiment>

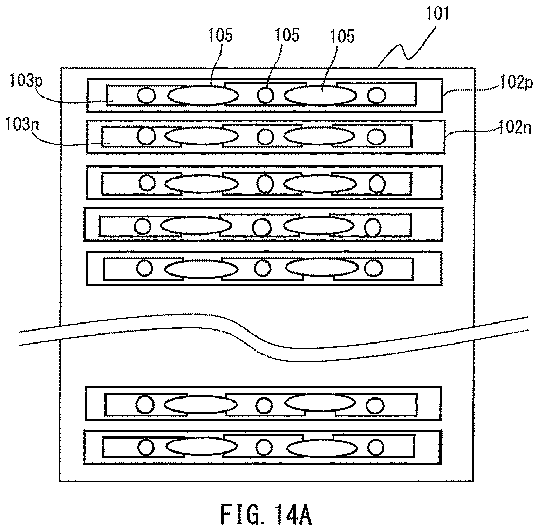

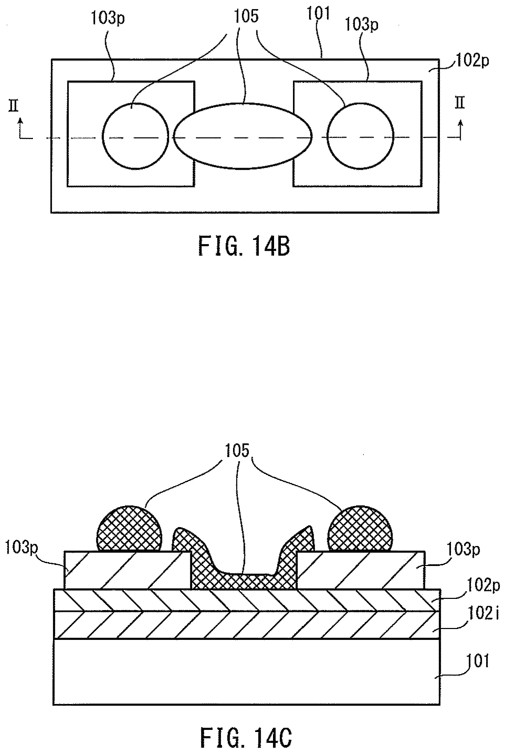

FIG. 14A is a schematic plan view of a photovoltaic device in the present embodiment. FIG. 14B is an enlarged schematic view of a portion of the photovoltaic device 1E of FIG. 14A, and FIG. 14C is a cross-sectional view of the portion of the photovoltaic device 1D shown in FIG. 14B taken along line II-II. FIGS. 14B and 14C show some of the p-type electrodes 103p on the associated p-type amorphous semiconductor strips 102p; however, such a construction also applies to the n-type electrodes 103n on the n-type amorphous semiconductor strips 102n. In FIGS. 14A to 14C, the same components as in the first embodiment are labeled with the same characters as in the first embodiment.

As shown in FIGS. 14A to 14C, the photovoltaic device 1E in the present embodiment is similar to the device in fourth embodiment in that pieces of a metal paste 105 are provided on the n-type and p-type electrodes 103n and 103p, but are different from the device in the fourth embodiment in that, in the photovoltaic device 1E, adjacent n-type electrodes 103n are connected via a metal paste 105 piece and adjacent p-type electrodes 103p are connected via a metal paste 105 piece.

In the photovoltaic device 1E, the area on which the metal paste 105 is present is larger than that in the photovoltaic device 1D in the fourth embodiment, which means a larger area where it is in contact with the wiring sheet 300 when joined to the wiring sheet 300. This provides wiring connection with a lower resistance than in the fourth embodiment when the wiring sheet 300 is joined to the photovoltaic device 1E. Further, since the area where the photovoltaic device 1E is in contact with the wiring sheet 300 is larger, the adhesion between the wiring sheet 300 and photovoltaic device 1E is larger than that for the fourth embodiment.

### <Seventh Embodiment>

In the first embodiment described above, the light-receiving face of the silicon substrate 101 has a texture; in addition, the back face of the silicon substrate 101 may have a texture.

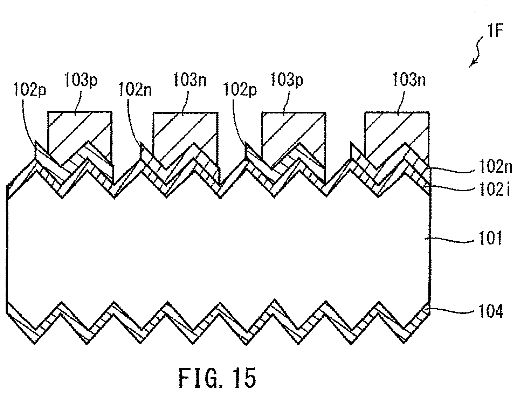

FIG. 15 is a schematic cross-sectional view of a photovoltaic device in the present embodiment. As shown in FIG. 15, in the photovoltaic device 1F, not only the light-receiving face of the silicon substrate 101 but also the back face has a texture. An i-type amorphous semiconductor layer 102i, n-type amorphous semiconductor strips 102n and p-type amorphous semiconductor strips 102p are provided along the irregularities of the texture on the back face of the silicon substrate 101.

In implementations where the back face of the silicon substrate 101 has a texture, when n-type and p-type amorphous semiconductor strips 102n and 102p and electrodes 103 (103n and 103p) are formed using a photomask, the thickness of and the light exposure for the resist is not uniform, making it difficult to provide a desired geometry. In the present embodiment, a texture is formed on the back face of the silicon substrate 101 and, for example, a shadow mask as in the first embodiment is used to form n-type and p-type amorphous semiconductor strips 102n and 102p and electrodes 103 (103n and 103p) with a desired geometry.

It should be noted that, in the present embodiment, any of the electrode patterns in the second and third embodiments described above may be used. Further, similar to the fourth and fifth embodiments described above, pieces of a metal paste 105 may be provided on electrodes and metal paste 105 pieces may be provided between electrodes, and metal paste 105 pieces bridging and connecting electrodes may be provided.

If the back face of the silicon substrate 101 has a texture, the area where the n-type and p-type amorphous semiconductor strips 102n and 102p are in contact with the electrodes 103 (103n and 103p) is larger, reducing the contact resistance between the amorphous semiconductor strips 102n and 102p and the electrodes 103. Further, if metal paste 105 pieces are provided on the electrodes 103, the contact area is larger, increasing the adhesive strength between the electrodes 103 and the metal paste 105 pieces. As the adhesive strength increases, the reliability of the photovoltaic device 1 produced increases. Further, if the light-receiving face and back face of the silicon substrate 101 have a texture, the front face and back face of the silicon substrate 101 are mirror images of each other, which means a smaller stress on the silicon substrate 101. Electrodes 103 spaced apart from each other are provided on the silicon substrate 101 with this property, further preventing the silicon substrate 101 from warping.

### <Eighth Embodiment>

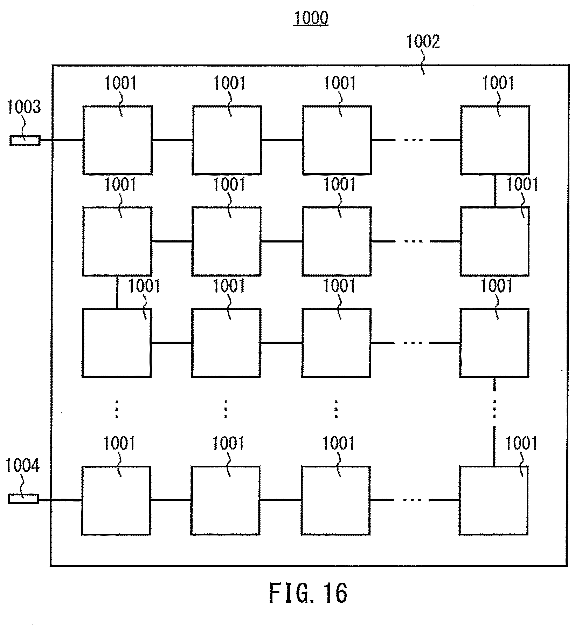

The present embodiment describes a photovoltaic module including the photovoltaic device in at least one of the first to seventh embodiments described above. FIG. 16 is a schematic diagram of a photovoltaic module in the present embodiment. The photovoltaic module 1000 includes a plurality of photovoltaic devices 1001, a cover 1002, and output terminals 1003 and 1004.

Each of the photovoltaic devices 1001 may be one of the photovoltaic devices 1 and 1B to 1F in the first to seventh embodiments, for example, joined to a wiring sheet. Alternatively, an array of such photovoltaic devices connected in series may be provided on a wiring sheet, or, instead of being connected in series, such devices may be connected in parallel, or such devices may be connected in series and in parallel.

The cover 1002 is a weather resistant cover that covers a plurality of photovoltaic devices 1001. The cover 1002 includes, for example, a transparent base (for example, glass) located adjacent to the light-receiving faces of the photovoltaic devices 1001, a back base (for example, glass, resin sheet, etc.) provided on the back faces of the photovoltaic devices 1001, and a seal material (for example, EVA) for sealing the gap between the transparent base and resin base.

The output terminal 1003 is connected to the one of the photovoltaic devices 1001 connected in series that is located at one end of the series.

The output terminal 1004 is connected to the one of the photovoltaic devices 1001 connected in series that is located at the other end of the series.

The photovoltaic module 1000 is not limited to the above configuration and may have any configuration as long as at least one of the photovoltaic devices 1001 is constituted by one of the photovoltaic devices in the first to seventh embodiments.

### <Ninth Embodiment>

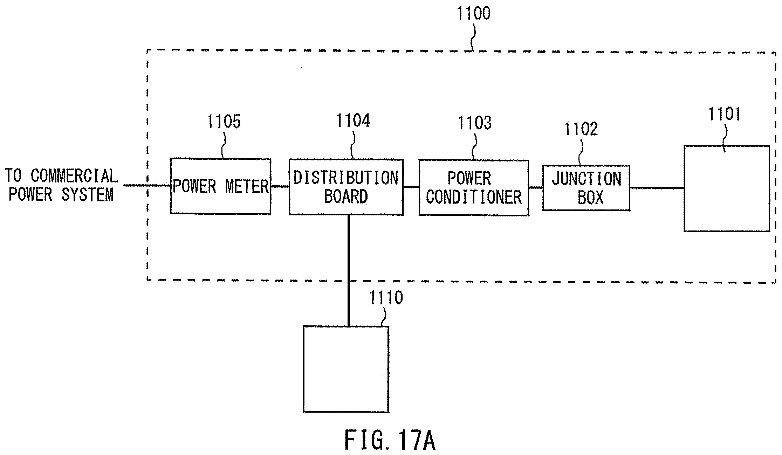

FIG. 17A is a schematic diagram of a solar power generation system in the present embodiment. The solar power generation system 1100 includes a photovoltaic module array 1101, a junction box 1102, a power conditioner 1103, a distribution board 1104, and a power meter 1105. The solar power generation system 1100 may include additional functions such as "home energy management system (HEMS) or "building energy management system (BEMS). This makes it possible to monitor the amount of power produced by the solar power generation system 1100 and to monitor and control the power consumption of electric devices connected to the solar power generation system 1100, thereby reducing energy consumption.

The junction box 1102 is connected with the photovoltaic module array 1101. The power conditioner 1103 is connected with the junction box 1102. The distribution board 1104 is connected with the power conditioner 1103 and electric device 1110. The power meter 1105 is connected with the distribution board 1104 and a commercial power network.

The photovoltaic module array 1101 converts sunlight to electricity to generate DC power, and supplies the generated DC power to the junction box 1102.

The junction box 1102 receives the DC power generated by the photovoltaic module array 1101 and supplies the received DC power to the power conditioner 1103.

The power conditioner 1103 converts the DC power received from the junction box 1102 to AC power and supplies the resulting AC power to the distribution board 1104.

The distribution board 1104 supplies the AC power received from the power conditioner 1103 and/or commercial power received via the power meter 1105 to the electric device 1110. If the AC power received from the power conditioner 1103 is larger than the power consumption of the electric device 1110, the distribution board 1104 supplies the residual AC power to the commercial power network via the power meter 1105.

The power meter 1105 measures the amount of power that is directed from the commercial power system to the distribution board 1104 and measures the amount of power that is directed from the distribution board 1104 to the commercial power system.

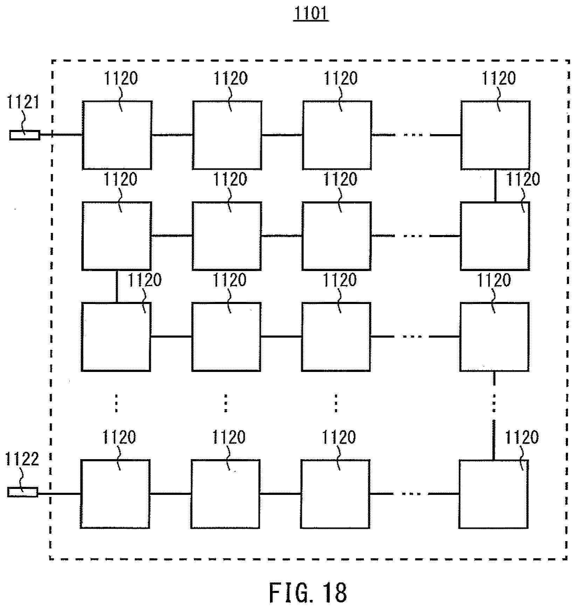

FIG. 18 is a schematic diagram of the photovoltaic module array 1101 of FIG. 17A. Referring to FIG. 18, the photovoltaic module array 1101 includes a plurality of photovoltaic modules 1120 and output terminals 1121 and 1122.

The photovoltaic modules 1120 form an array and are connected in series. Each of the photovoltaic modules 1120 is constituted by the photovoltaic module 1000 of FIG. 16.

The output terminal 1121 is connected to the one of the photovoltaic modules 1120 connected in series that is located at one end of the series.

The output terminal 1122 is connected to the one of the photovoltaic modules 1120 connected in series that is located at the other end of the series.

The operation of the solar power generation system 1100 will be described. The photovoltaic module array 1101 converts sunlight to electricity to generate DC power, and supplies the generated DC power to the power conditioner 1103 via the junction box 1102.

The power conditioner 1103 converts the DC power received from the photovoltaic module array 1101 to AC power and supplies the resulting AC power to the distribution board 1104.

If the AC power received from the power conditioner 1103 is equal to or larger than the power consumption of the electric device 1110, the distribution board 1104 supplies the AC power received from the power conditioner 1103 to the electric device 1110. Then, the distribution board 1104 supplies the residual AC power to the commercial power network via the power meter 1105.

If the AC power received from the power conditioner 1103 is smaller than the power consumption of the electric device 1110, the distribution board 1104 supplies AC power received from the commercial power system and the AC power received from the power conditioner 1103 to the electric device 1110.

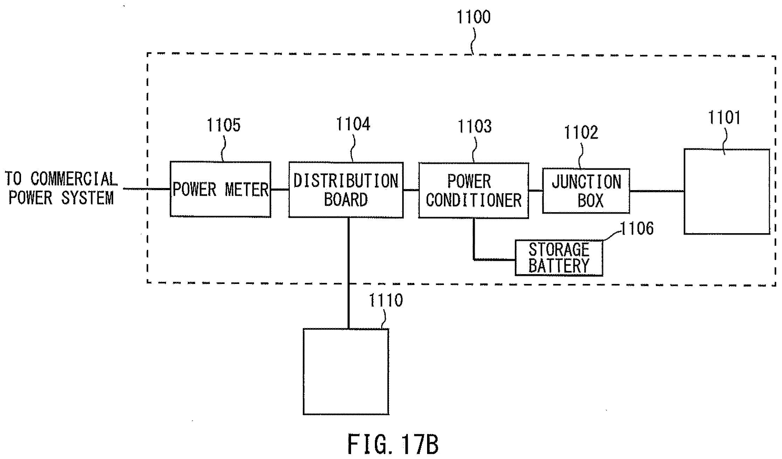

The solar power generation system in the present embodiment is not limited to the configuration shown in FIGS. 17A and 18 and may have any configuration as far as one of the photovoltaic devices in the first to seventh embodiments is used. Further, as shown in FIG. 17B, a storage battery 1106 may be connected to the power conditioner 1103. This makes it possible to reduce output variations caused by variations in the amount of solar radiation, and supply power accumulated in the storage battery 1106 during the time periods in which there is no sunshine. The storage battery 1106 may be incorporated in the power conditioner 1103.

### <Tenth Embodiment>

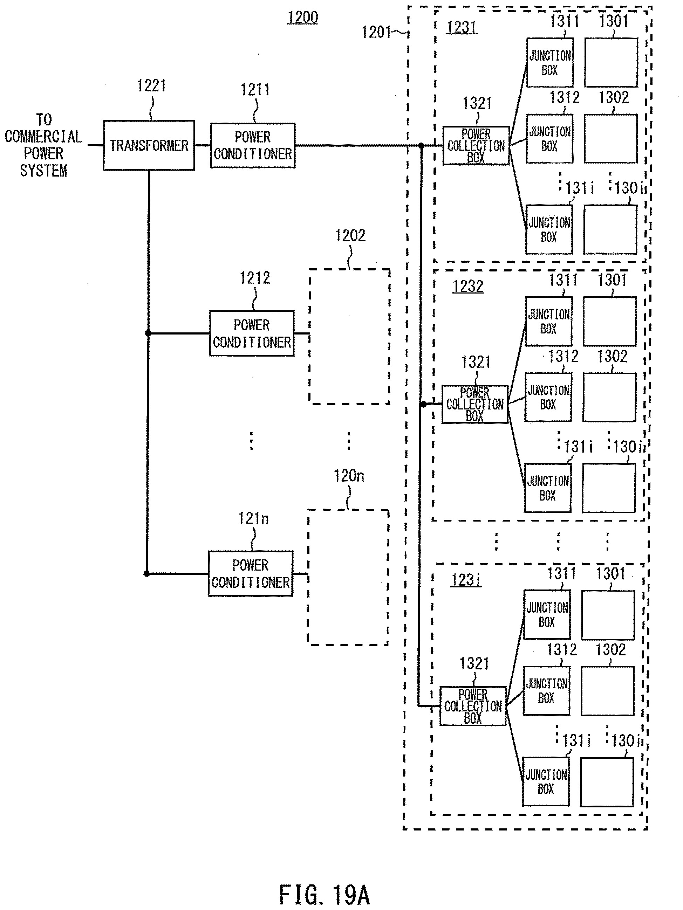

FIG. 19A is a schematic diagram of a solar power generation system in the present embodiment. The solar power generation system 1200 includes sub-systems 1201 to 120n (n is an integer larger than 1), power conditioners 1211 to 121n and a transformer 1221. The solar power generation system 1200 is of a larger scale than the solar power generation system 1100 shown in FIGS. 17A or 17B.

The power conditioners 1211 to 121n are connected with the respective sub-systems 1201 to 120n.

The transformer 1221 is connected with the power conditioners 1211 to 121n and a commercial power system.

Each of the sub-systems 1201 to 120n is composed of module systems 1231 and 123j (j is an integer larger than 1).

Each of the module systems 1231 to 123j includes photovoltaic module arrays 1301 to 130i (i is an integer larger than 1), junction boxes 1311 to 131i and a power collection box 1321.

Each of the photovoltaic module arrays 1301 to 130i has the same configuration as the photovoltaic module array 1101 of FIG. 18.

The junction boxes 1311 to 131i are connected with the respective photovoltaic module arrays 1301 to 130i.

The power collection box 1321 is connected with the junction boxes 1311 to 131i. The j power collection boxes 1321 of the sub-system 1201 are connected with the power conditioner 1211. The j power collection boxes 1321 of the sub-system 1202 are connected with the power conditioner 1212. Other power collection boxes are connected with other power conditioners in a similar manner, and the j power collection boxes 1321 of the sub-system 120n are connected with the power conditioner 121n.

The i photovoltaic module arrays 1301 to 130i of the module system 1231 convert sunlight to electricity to generate DC power, and supply the generated DC power to the power collection box 1321 via the respective junction boxes 1311 to 131i. The i photovoltaic module arrays 1301 to 130i of the module system 1232 convert sunlight to electricity to generate DC power, and supply the generated DC power to the power collection box 1321 via the respective junction boxes 1311 to 131i. Other arrays operate in a similar manner, and the i photovoltaic module arrays 1301 to 130i of the module system 123j convert sunlight to electricity to generate DC power, and supply the generated DC power to the power collection box 1321 via the respective junction boxes 1311 to 131i.

Then, the j power collection boxes 1321 of the sub-system 1201 supply their DC power to the power conditioner 1211.

In a similar manner, the j power collection boxes 1321 of the sub-system 1202 supply their DC power to the power conditioner 1212.

Other power collection boxes operate in a similar manner, and the j power collection boxes 1321 of the sub-system 120n supply their DC power to the power conditioner 121n.

The power conditioners 1211 to 121n change the DC power received from the respective sub-systems 1201 to 120n to AC power and supply the resulting AC power to the transformer 1221.

The transformer 1221 receives the AC power from the power conditioners 1211 to 121n, converts the voltage level of the received AC power and supplies the resulting power to the commercial power system.

The solar power generation system in the present embodiment is not limited to the configuration shown in FIG. 19A, and may have any configuration as far as one of the photovoltaic devices in the first to seventh embodiments is used.

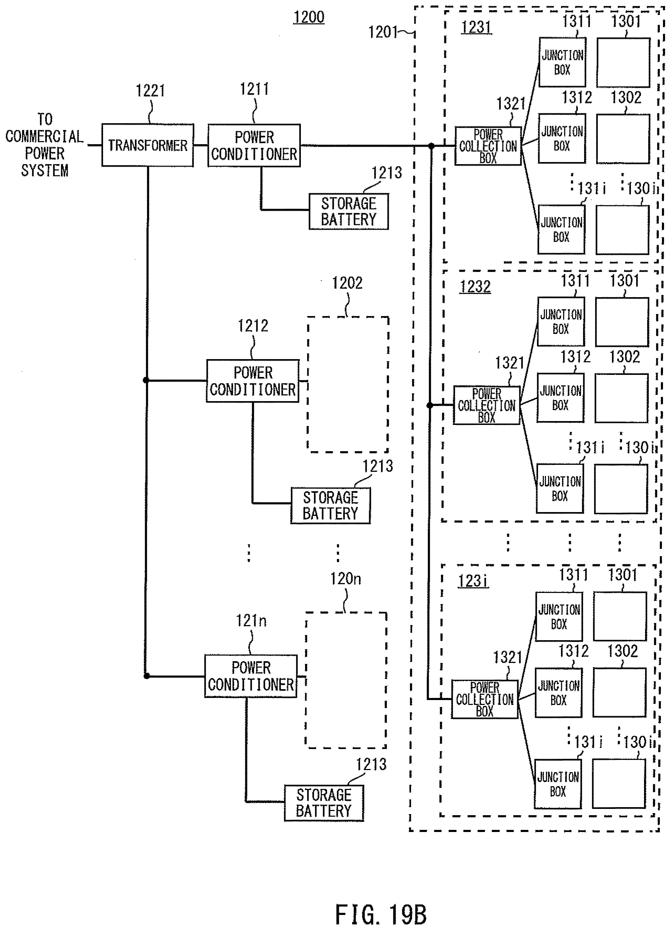

Further, as shown in FIG. 19B, a storage battery 1213 may be connected with each of the power conditioners 1211 to 121n, and each storage battery 1213 may be incorporated in the associated one of the power conditioners 1211 and 121n. In such implementations, each of the power conditioners 1211 to 121n may convert some or all of the DC power received from its associated power collection boxes 1321 as appropriate and accumulate the resulting power in its associated storage battery 1213. Power accumulated in each storage battery 1213 is supplied to the associated one of the power conditioners 1211 to 121n depending on the amount of power generated by the associated one of the sub-systems 1201 to 120n, and converted appropriately and supplied to the transformer 1221.

### <Variations>

The photovoltaic devices in the first to tenth embodiments of the present invention have been described. The photovoltaic devices of the present invention are not limited to the above embodiments, and various modifications are possible within the scope of the invention. Further, some or all of the embodiments may be combined as necessary.
(1) The first embodiment described above describes an n-type silicon substrate 101; alternatively, a p-type silicon substrate 101 may be used.
(2) The first embodiment described above describes that an antireflective film 104 is provided on the light-receiving face of the silicon substrate 101; alternatively, no antireflective film 104 may be provided. Alternatively, instead of an antireflective film 104, an n⁺ layer with a high concentration of an n-type dopant diffused therein may be provided. Alternatively, an n⁺ layer with a high concentration of an n-type dopant diffused therein may be provided between the light-receiving face of the silicon substrate 101 and an antireflective film 104.
(3) The first and second embodiments described above describe implementations where a plurality of electrodes 103 (103n and 103p) and 113 (113n and 113p) are provided on n-type amorphous semiconductor strips 102n and 1002n and p-type amorphous semiconductor strips 102p and 1002p, and a plurality of electrodes 103 and 113 on the n-type amorphous semiconductor strips 102n and 1002n and p-type amorphous semiconductor strips 102p and 1002p are connected via wiring sheets. Alternatively, for example, a plurality of separate electrodes spaced apart from each other may be provided on each semiconductor strip of one of the group of n-type amorphous semiconductor strips and the group of p-type amorphous semiconductor strips, and one continuous electrode may be provided on each semiconductor strip of the other group of semiconductor strips.
(4) In the photovoltaic devices in the second and third embodiments described above, pieces of a metal paste 105 may be provided similar to those in the fourth and fifth embodiments. That is, starting from the second embodiment, for example, pieces of a metal paste 105 may be provided on the electrodes 113 and metal paste 105 pieces may be provided between the electrode grids 113a of the electrodes 113, or metal paste 105 pieces may be provided to bridge the electrode grids 113a of the electrodes 113. Alternatively, starting from the third embodiment, pieces of a metal paste 105 may be provided on n-type and p-type electrodes 103n and 103p and metal paste 105 pieces may be provided between the n-type electrodes 103n and p-type electrodes 103p, or metal paste 105 pieces may be provided on the n-type and p-type electrodes 103n and 103p and metal paste 105 pieces may be provided to bridge the n-type electrodes 103n and metal paste 105 pieces may be provided to bridge the p-type electrodes 103p.

## Claims

1. A photovoltaic device (1) comprising:
a semiconductor substrate (101);
a first amorphous semiconductor strip (102p) of a first conductivity type provided on one face of the semiconductor substrate (101);
a second amorphous semiconductor strip (102n) of a second conductivity type, the second conductivity type being opposite to the first conductivity type, the second amorphous semiconductor strip (102n) being provided on the one face of the semiconductor substrate (101) and located adjacent to the first amorphous semiconductor strip (102p) in an in-plane direction of the semiconductor substrate (101);
wherein an i-type amorphous semiconductor layer (102i) is provided on the back face of the semiconductor substrate (101) and the said first and second amorphous semiconductor strips (102n, 102p) are provided on the said i-type amorphous semiconductor layer (102i);
a plurality of electrodes (103) spaced apart from each other and provided on at least one of the first and second amorphous semiconductor strips (102p, 102n); and
a conductive part provided on the plurality of electrodes (103) for electrically connecting the plurality of electrodes (103), **characterized in that**
at least one of the first amorphous semiconductor strip (102p) and the second amorphous semiconductor strip (102n) has reduced-thickness regions (TD),
the reduced-thickness region (TD) is defined by a first point (A) and a second point (B) as measured along an in-plane direction of the first amorphous semiconductor strip (102p) or the second amorphous semiconductor strip (102n), where the first point (A) is the point on the first or second amorphous semiconductor strip (102p, 102n) with the maximum film thickness, and the second point (B) is the point on the first or second amorphous semiconductor strip (102p, 102n) as measured along an in-plane direction at which the decreasing rate of the film thickness changes from a first decreasing rate to a second decreasing rate that is larger than the first decreasing rate or the value of the decreasing rate of the film thickness changes from negative to positive.

2. The photovoltaic device (1) according to claim 1, wherein
the first amorphous semiconductor strip (102p) is comb-shaped;
the second amorphous semiconductor strip (102n) is comb-shaped;
each of the plurality of electrodes (103) includes a first electrode portion extending generally in a first direction on the semiconductor substrate (101) and a plurality of second electrode portions extending generally in a second direction and being in contact with one side of the first electrode portion, the second direction being perpendicular to the first direction, and
the plurality of electrodes (103) are disposed such that the first electrode portions are spaced apart from each other in the first direction.

3. The photovoltaic device (1) according to claim 1, wherein some of the plurality of electrodes (103) provided on the first and second amorphous semiconductor strips (102p, 102n) are located at positions that correspond to positions between the electrodes (103) on the adjacent semiconductor strips (102p, 102n).

4. The photovoltaic device (1) according to claim 1 or 2, wherein the conductive part includes a conductive layer made of a metal paste (105).

5. The photovoltaic device (1) according to claim 4, wherein the conductive layer is located on the plurality of electrodes (103) and between adjacent ones of the electrodes (103).

6. The photovoltaic device (1) according to claim 4, wherein the conductive layer is provided on the plurality of electrodes (103) and provided so as to bridge adjacent ones of the electrodes (103).

7. The photovoltaic device (1) according to claim 1 or 2, wherein at least one face of the semiconductor substrate (101) has a texture.

8. The photovoltaic device (1) according to claim 1 or 2, wherein an insulating layer is provided in a region that is other than a region in which the conductive part is in contact with the plurality of electrodes (103).

## Patentansprüche

1. Photovoltaik-Vorrichtung (1), umfassend:
ein Halbleitersubstrat (101);
einen ersten amorphen Halbleiterstreifen (102p) eines ersten Leitfähigkeitstyps, der auf einer Fläche des Halbleitersubstrats (101) vorgesehen ist;
einen zweiten amorphen Halbleiterstreifen (102n) eines zweiten Leitfähigkeitstyps, wobei der zweite Leitfähigkeitstyp dem ersten Leitfähigkeitstyp entgegengesetzt ist, wobei der zweite amorphe Halbleiterstreifen (102n) auf der einen Fläche des Halbleitersubstrats (101) vorgesehen und dem ersten amorphen Halbleiterstreifen (102p) in einer Richtung in der Ebene des Halbleitersubstrats (101) benachbart gelegen ist;
wobei eine amorphe Halbeiterschicht (102i) vom i-Typ auf der Rückseite des Halbleitersubstrats (101) vorgesehen ist und die ersten und zweiten amorphen Halbleiterstreifen (102n, 102p) auf der amorphen Halbleiterschicht (102i) vom i-Typ vorgesehen sind;
eine Vielzahl von Elektroden (103), die voneinander beabstandet sind und auf zumindest einem der ersten und zweiten amorphen Halbleiterstreifen (102p, 102n) vorgesehen sind; und
einen leitfähigen Teil, der auf der Vielzahl von Elektroden (103) vorgesehen ist, um die Vielzahl von Elektroden (103) elektrisch zu verbinden, **dadurch gekennzeichnet, dass**
zumindest einer des ersten amorphen Halbleiterstreifens (102p) und des zweiten amorphen Halbleiterstreifens (102n) Gebiete (TD) mit reduzierter Dicke aufweist,
das Gebiet (TD) mit reduzierter Dicke durch einen ersten Punkt (A) und einen zweiten Punkt (B) definiert ist, wie entlang einer Richtung in der Ebene des ersten amorphen Halbleiterstreifens (102p) oder des zweiten amorphen Halbleiterstreifens (102n) gemessen, wo der erste Punkt (A) der Punkt auf dem ersten oder zweiten amorphen Halbleiterstreifen (102p, 102n) mit der maximalen Filmdicke ist und der zweite Punkt (B) der Punkt auf dem ersten oder zweiten amorphen Halbleiterstreifen (102p, 102n) ist, wie entlang einer Richtung in der Ebene gemessen, bei dem sich die Abnahmerate der Filmdicke von einer ersten Abnahmerate zu einer zweiten Abnahmerate ändert, die größer als die erste Abnahmerate ist, oder der Wert der Abnahmerate der Filmdicke sich von negativ in positiv ändert.

2. Photovoltaik-Vorrichtung (1) nach Anspruch 1, wobei
der erste amorphe Halbleiterstreifen (102p) kammförmig ist;
der zweite amorphe Halbleiterstreifen (102n) kammförmig ist;
jede der Vielzahl von Elektroden (103) einen ersten Elektrodenbereich umfasst, der sich im Allgemeinen in einer ersten Richtung auf dem Halbleitersubstrat (101) erstreckt, und eine Vielzahl zweiter Elektrodenbereiche, die sich im Allgemeinen in einer zweiten Richtung erstrecken und mit einer Seite des ersten Elektrodenbereichs in Kontakt sind, wobei die zweite Richtung senkrecht zur ersten Richtung ist, und
die Vielzahl von Elektroden (103) so angeordnet ist, dass die ersten Elektrodenbereiche in der ersten Richtung voneinander beabstandet sind.

3. Photovoltaik-Vorrichtung (1) nach Anspruch 1, wobei einige der Vielzahl von Elektroden (103), die auf den ersten und zweiten amorphen Halbleiterstreifen (102p, 102n) vorgesehen sind, an Positionen gelegen sind, die Positionen zwischen den Elektroden (103) auf den benachbarten Halbleiterstreifen (102p, 102n) entsprechen.

4. Photovoltaik-Vorrichtung (1) nach Anspruch 1 oder 2, wobei der leitfähige Teil eine aus einer Metallpaste (105) bestehende leitfähige Schicht umfasst.

5. Photovoltaik-Vorrichtung (1) nach Anspruch 4, wobei die leitfähige Schicht auf der Vielzahl von Elektroden (103) und zwischen benachbarten der Elektroden (103) gelegen ist.

6. Photovoltaik-Vorrichtung (1) nach Anspruch 4, wobei die leitfähige Schicht auf der Vielzahl von Elektroden (103) vorgesehen ist und so vorgesehen ist, das sie benachbarte der Elektroden (103) überbrückt.

7. Photovoltaik-Vorrichtung (1) nach Anspruch 1 oder 2, wobei zumindest eine Fläche des Halbleitersubstrats (101) eine Textur aufweist.

8. Photovoltaik-Vorrichtung (1) nach Anspruch 1 oder 2, wobei eine isolierende Schicht in einem Gebiet vorgesehen ist, das ein anderes als ein Gebiet ist, in welchem der leitfähige Teil mit der Vielzahl von Elektroden (103) in Kontakt ist.

## Revendications

1. Dispositif photovoltaïque (1) comprenant :
un substrat semi-conducteur (101) ;
une première bande de semi-conducteur amorphe (102p) d'un premier type de conductivité fournie sur une face du substrat semi-conducteur (101) ;
une seconde bande de semi-conducteur amorphe (102n) d'un second type de conductivité, le second type de conductivité étant opposé au premier type de conductivité, la seconde bande de semi-conducteur amorphe (102n) étant fournie sur l'une face du substrat semi-conducteur (101) et située adjacente à la première bande de semi-conducteur amorphe (102p) dans une direction dans le plan du substrat semi-conducteur (101) ;
dans lequel une couche de semi-conducteur amorphe de type i (102i) est fournie sur la face arrière du substrat semi-conducteur (101) et lesdites première et seconde bandes de semi-conducteur amorphe (102n, 102p) sont fournies sur ladite couche de semi-conducteur amorphe de type i (102i) ;
une pluralité d'électrodes (103) espacées les unes des autres et fournies sur au moins une des première et seconde bandes de semi-conducteur amorphe (102p, 102n) ; et
une partie conductrice fournie sur la pluralité d'électrodes (103) pour connecter électriquement la pluralité d'électrodes (103), **caractérisé en ce que**
au moins une de la première bande de semi-conducteur amorphe (102p) et de la seconde bande de semi-conducteur amorphe (102n) présente des régions d'épaisseur réduite (TD),
la région d'épaisseur réduite (TD) est définie par un premier point (A) et un second point (B) tels que mesurés le long d'une direction dans le plan de la première bande de semi-conducteur amorphe (102p) ou de la seconde bande de semi-conducteur amorphe (102n), où le premier point (A) est le point sur la première ou la seconde bande de semi-conducteur amorphe (102p, 102n) avec l'épaisseur de film maximale, et le second point (B) est le point sur la première ou la seconde bande de semi-conducteur amorphe (102p, 102n) tel que mesuré le long d'une direction dans le plan en lequel le taux de diminution de l'épaisseur de film passe d'un premier taux de diminution à un second taux de diminution qui est plus grand que le premier taux de diminution ou la valeur du taux de diminution de l'épaisseur de film passe de négative à positive.

2. Dispositif photovoltaïque (1) selon la revendication 1, dans lequel
la première bande de semi-conducteur amorphe (102p) est en forme de peigne ;
la seconde bande de semi-conducteur amorphe (102n) est en forme de peigne ;
chacune de la pluralité d'électrodes (103) inclut une première partie d'électrode s'étendant globalement dans une première direction sur le substrat semi-conducteur (101) et une pluralité de secondes parties d'électrode s'étendant globalement dans une seconde direction et étant en contact avec un côté de la première partie d'électrode, la seconde direction étant perpendiculaire à la première direction, et
la pluralité d'électrodes (103) sont disposées de telle sorte que les premières parties d'électrode sont espacées les unes des autres dans la première direction.

3. Dispositif photovoltaïque (1) selon la revendication 1, dans lequel certaines de la pluralité d'électrodes (103) fournies sur les première et seconde bandes de semi-conducteur amorphe (102p, 102n) sont situées en des positions qui correspondent à des positions entre les électrodes (103) sur les bandes de semi-conducteur (102p, 102n) adjacentes.

4. Dispositif photovoltaïque (1) selon la revendication 1 ou 2, dans lequel la partie conductrice inclut une couche conductrice constituée d'une pâte de métal (105).

5. Dispositif photovoltaïque (1) selon la revendication 4, dans lequel la couche conductrice est située sur la pluralité d'électrodes (103) et entre des électrodes adjacentes des électrodes (103).

6. Dispositif photovoltaïque (1) selon la revendication 4, dans lequel la couche conductrice est fournie sur la pluralité d'électrodes (103) et fournie de façon à assurer le pontage entre des électrodes adjacentes des électrodes (103).

7. Dispositif photovoltaïque (1) selon la revendication 1 ou 2, dans lequel au moins une face du substrat semi-conducteur (101) présente une texture.

8. Dispositif photovoltaïque (1) selon la revendication 1 ou 2, dans lequel une couche isolante est fournie dans une région qui est autre qu'une région dans laquelle la partie conductrice est en contact avec la pluralité d'électrodes (103).
